(19) Europäisches Patentamt
European Patent Office
Office européen des brevets

(11) EP 1 302 780 B1

(12) EUROPÄISCHE PATENTSCHRIFT

(45) Veröffentlichungstag und Bekanntmachung des Hinweises auf die Patenterteilung:
**12.12.2007 Patentblatt 2007/50**

(51) Int Cl.:
***G01R 33/34*** *(2006.01)*

(21) Anmeldenummer: **02022542.1**

(22) Anmeldetag: **08.10.2002**

(54) **Supraleitende NMR-Resonatoren mit makroskopisch homogener Verteilung des Supraleiters**

Superconducting NMR resonators with a macroscopically homogeneous distribution of the superconductor

Résonateurs RMN supraconducteurs avec une distribution macroscopiquement homogène du supraconducteur

(84) Benannte Vertragsstaaten:
**CH DE FR GB LI**

(30) Priorität: **11.10.2001 DE 10150131**

(43) Veröffentlichungstag der Anmeldung:
**16.04.2003 Patentblatt 2003/16**

(73) Patentinhaber: **Bruker BioSpin AG**
**8117 Fällanden (CH)**

(72) Erfinder: **Marek, Daniel**
**5103 Möriken (CH)**

(74) Vertreter: **Kohler Schmid Möbus**
**Patentanwälte**
**Ruppmannstrasse 27**
**70565 Stuttgart (DE)**

(56) Entgegenhaltungen:
**WO-A-96/39636          WO-A-99/24821**
**WO-A-99/24845**

## Beschreibung

Die Erfindung betrifft einen NMR(= Kernspinresonanz)-Resonator mit mindestens einem HF(= Hochfrequenz)-Resonator zum Aussenden und/oder Empfangen von HF-Signalen auf einer oder mehreren gewünschten Resonanzfrequenzen in eine und/oder aus einer Messprobe in einem um einen Koordinatenursprung (x,y,z = 0) angeordneten Untersuchungsvolumen einer NMR-Apparatur mit einer Einrichtung zur Erzeugung eines homogenen Magnetfelds $B_0$ in Richtung einer z-Achse, wobei zwischen $z = -|z_1|$ und $z = +|z_2|$ supraleitfähige, induktiv und zum Teil auch kapazitiv wirkende Leiterstrukturen des HF-Resonators im wesentlichen auf einer Fläche, die in Flächenelemente eingeteilt werden kann, welche sich lediglich in ihrer z-Position unterscheiden, im radialen (x,y) Abstand von der Messprobe angeordnet sind.

Eine solche Anordnung ist aus der US-A 5,585,723 bekannt.

Die vorliegende Erfindung betrifft das Gebiet der hochauflösenden Kernspinresonanz (NMR), insbesondere die Gestaltung von supraleitenden Resonatoren für den Empfang des NMR-Signals aus der NMR-Messprobe.

NMR ist zwar eine sehr aussagekräftige Methode zur Strukturanalyse von chemischen Verbindungen, sie ist jedoch nicht sehr empfindlich. Um die Empfindlichkeit zu steigern, werden deshalb nach dem heutigen Stand der Technik gekühlte normalleitende und insbesondere supraleitende Resonatoren verwendet, mit denen das S/N Verhältnis wesentlich gesteigert werden kann. Solche Resonatoren sind z.B. in [1] beschrieben.

Das wesentliche Problem bei der Verwendung von Supraleitern für die Herstellung von NMR-Resonatoren ist ihre statische Magnetisierung. Bei einem Supraleiter vom Typ II wird diese Magnetisierung durch eingeprägte Ströme erzeugt, die in geschlossenen Bahnen innerhalb des Supraleiters fließen, und die durch die Vorgeschichte des Supraleiters bestimmt sind [2]. Diese Ströme können im aktiven Bereich der Messprobe starke, inhomogene Feldstörungen erzeugen, die eine Verzerrung der Resonanzlinien im NMR-Spektrum zur Folge haben. Solange die äußeren Verhältnisse unverändert bleiben, fließen diese Ströme infolge des Null-Widerstandes des Supraleiters praktisch für unbeschränkte Zeiten weiter.

Eine Anzahl von Verfahren ([2], [3], [4]) sind bereits publiziert worden, um diese Magnetisierung zu minimieren, doch sind diese alle kompliziert und weisen weitere Nachteile auf, die weiter unten beschrieben sind. Im Weiteren sind auch supraleitende Spulenanordnungen beschrieben worden [5], welche zwar auch Störfelder verursachen können, doch werden diese durch eine Begrenzung des aktiven Messbereiches mit Hilfe von normalleitenden Verbindungselementen minimiert. Diese Spulenanordnungen [5] sind den oben erwähnten Lösungen resp. Verfahren [1-3] bezüglich Füllfaktor und erreichbaren HF-Feldstärken überlegen, besitzen jedoch den Nachteil, dass die Kreisgüte des HF-Resonators durch die notwendige Verwendung von normalleitenden Komponenten im HF-Resonator signifikant reduziert wird.

Die bekannten Maßnahmen, um den Einfluss der Magnetisierung zu minimieren, sind folgende:

1. Unterteilung der Breite des Supraleiters in n einzelne Längsstreifen ([1], [5]), wobei n möglichst groß sein sollte. Dadurch werden die maximalen Ströme, die in diesen Längsstreifen fließen können, und somit auch die maximal mögliche Magnetisierung des Supraleiters um den Faktor n kleiner.

2. Die Magnetisierung gar nicht entstehen lassen, indem der Supraleiter erst dann abgekühlt wird, wenn er sich im statischen Feld des Magneten befindet. Patent [4] empfiehlt zudem, dass die Abkühlung langsam erfolgen soll.

3. Eine vorhandene Magnetisierung mit Hilfe eines Entmagnetisierungsprozesses größtenteils eliminieren ([2], [3]). Erreicht wird dies durch eine Sequenz abnehmender, transversaler Magnetfelder, die auf den Supraleiter einwirken. Dabei wird im Supraleiter eine Stromstruktur mit entgegengesetzten Strombereichen eingeprägt, wobei die Summe der einzelnen Magnetfeldbeiträge sich in guter Näherung aufheben soll.

Diese bekannten Verfahren haben jedoch entscheidende Nachteile:

1. Die unter Punkt 1 beschriebene Maßnahme hat wohl eine starke Verringerung der Magnetisierung zur Folge, doch die verbleibende Restmagnetisierung ist im Allgemeinen immer noch zu hoch für befriedigende Anwendungen in der hochauflösenden NMR.

2. Die unter Punkt 2 und 3 beschriebenen Verfahren können nur dann zufriedenstellend funktionieren, wenn die Position des Supraleiters in Bezug zum statischen Magnetfeld während des ganzen Messvorganges vollkommen unverändert bleibt, und wenn das statische Magnetfeld selbst während dieser Zeit ebenfalls unverändert bleibt. Vor allem ist es die Konstanz der Winkelposition, die normalerweise in der Praxis ungenügend gut erfüllt ist. Bereits eine Verkippung von nur 0.1 Grad in Bezug zum statische Magnetfeld kann zu derart großen Abschirmströmen im Supraleiter führen, dass die Feldhomogenität unzulässig stark verschlechtert wird.

Durch die Verkippung wird nämlich vom statischen Magnetfeld her ein zusätzlicher transversaler magnetischer Fluss auf die Oberfläche des Supraleiters gerichtet, und da der Supraleiter den bereits vorhandenen Fluss aufrecht zu erhalten versucht, wirkt er mit zusätzlichen Oberflächenströmen dagegen, so dass der Gesamtfluss durch den Supraleiter wieder dem ursprünglichen Wert entspricht. Diese Oberflächenströme sind es, die ein inhomogenes Feld am Ort der Messprobe erzeugen und dadurch die benötigte spektrale Auflösung unzulässig stark verschlechtern.
3. Die Verfahren ([2], [3], [4]) sind kompliziert durchzuführen und erfordern zusätzliche Einrichtungen im kritischen Bereich des NMR-Resonators.

Aufgabe der vorliegenden Erfindung ist es demgegenüber, eine neue Art von supraleitenden NMR-Resonatoren vorzustellen, bei denen zusätzliche, supraleitende Leiterstrukturen hinzugefügt werden, die möglichst gut vom eigentlichen HF-Resonator entkoppelt sind, und die den Störeinfluss, hervorgerufen durch die Magnetisierung des Supraleiters, so gut wie möglich kompensieren sollen.

Erfindungsgemäß wird diese Aufgabe bei einem NMR-Resonator mit den eingangs beschriebenen Merkmalen dadurch gelöst, dass auf der Fläche, die in Flächenelemente eingeteilt werden kann, welche sich lediglich in ihrer z-Position unterscheiden, zusätzlich eine Kompensations-Anordnung vorgesehen ist, die sich mindestens bis zu Werten $z < -|z_1| -0.5\,|r|$ und $z > +|z_2| + 0.5\,|r|$ erstreckt, wobei $|r|$ der kleinste vorkommende Abstand zwischen der Messprobe und der Kompensations-Anordnung bedeutet, dass die Kompensations-Anordnung weitere supraleitfähige Leiterstrukturen umfasst, welche HF-mäßig vom HF-Resonator weitgehend entkoppelt sind, dass die Leiterstrukturen der Kompensations-Anordnung und des HF-Resonators ihrerseits aus einzelnen, supraleitende Strukturen enthaltenden Flächenabschnitten (="Z-Strukturen") zusammengesetzt sind, die in Fläche, die in Flächenelemente eingeteilt werden kann, welche sich lediglich in ihrer z-Position unterscheiden, liegen, jeweils über die ganze Länge in z-Richtung der Leiterstrukturen der Kompensations-Anordnung und des HF-Resonators verlaufen, und deren supraleitende Strukturen so angeordnet sind, dass im Falle einer Zerlegung der Fläche der Z-Strukturen in eine Vielzahl kleiner, gleich großer Flächenelemente durch Anlegen eines homogenen Testmagnetfeldes entlang der Flächennormalen jedes Flächenelementes für alle Flächenelemente, die sich nur in ihrer z-Position unterscheiden, ein magnetisches Dipolmoment von weitgehend derselben Stärke induziert wird.

Die erfindungsgemäßen Resonatoren besitzen viele Vorteile:

■ Die komplizierten Verfahren ([2], [3], [4]) zur Entmagnetisierung des Supraleiters sind nicht mehr notwendig.

■ Externe Störfelder und mechanische Bewegungen des Resonators in Bezug zum statischen Magnetfeld erzeugen zwar eine Magnetisierung im Supraleiter, diese kann jedoch dank der oben erwähnten Kompensation nur einen minimierten Einfluss auf die Homogenität des statischen Magnetfeldes im aktiven Bereich der Messprobe ausüben. Dies gilt auch dann, wenn der Supraleiter sehr stark magnetisiert ist!

■ Bereits bekannte Spulenstrukturen [5] lassen sich viel freier und somit wirkungsvoller gestalten.

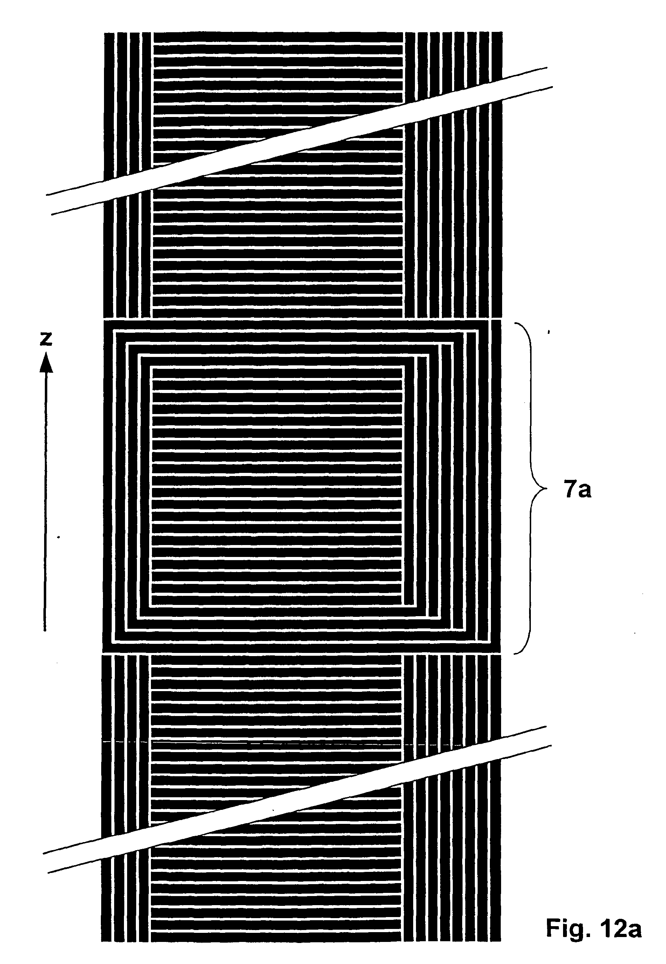

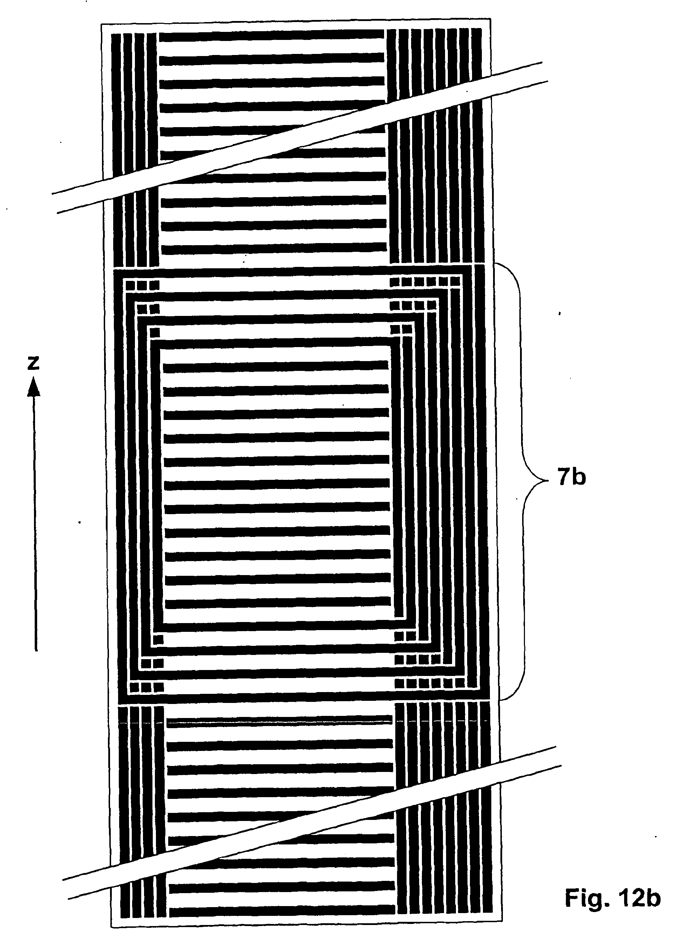

Beim erfindungsgemäßen Resonator werden die einzelnen supraleitfähigen Leiterteile, die den Hochfrequenz (HF)-Strom tragen und somit den HF-Resonator bilden, durch zusätzliche supraleitfähige Leiterteile ergänzt, die sowohl innerhalb des HF-Resonators wie auch in z-Richtung verlängernd, quasi-kontinuierlich angeordnet und HF-mäßig so gut wie möglich vom HF-Resonator entkoppelt sind, damit sie keinen HF-Strom tragen Fig. 12b zeigt eine nach diesem Prinzip aufgebaute Anordnung, wobei der HF-Resonator schraffiert und die zusätzlichen Leiterteile, die lediglich der Homogenisierung des $B_0$-Feldes im aktiven Messbereich dienen, schwarz dargestellt sind. Man erkennt deutlich, dass das supraleitfähige Material ziemlich homogen über die ganze Fläche des HF-Resonators und der zusätzlichen Leiterteile verteilt ist, was im Allgemeinen auch eine gleichmäßige Verteilung der Dipolmomente über die ganze Fläche zur Folge hat. Diese gleichmäßige Verteilung der Dipolmomente, die durch induzierte Ströme im Supraleiter entstehen, erzeugt ein praktisch homogenes Störfeld im Messvolumen und kann deshalb das NMR-Spektrum nicht mehr signifikant beeinflussen.

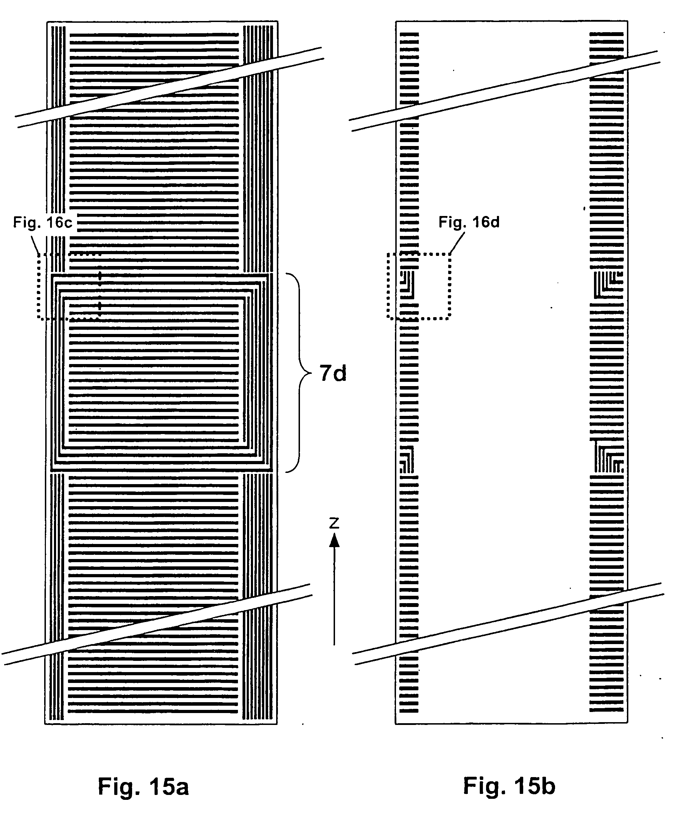

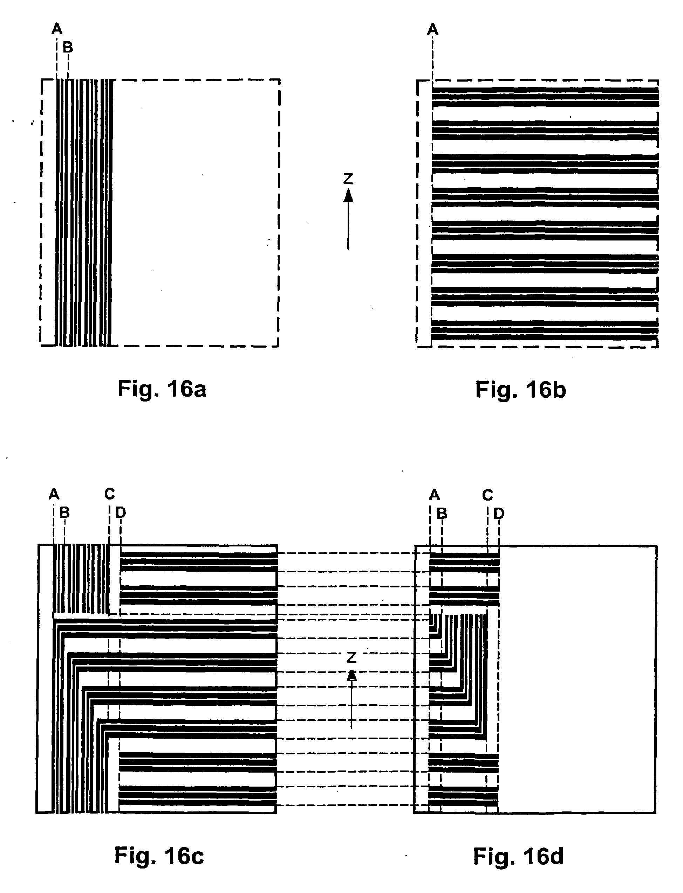

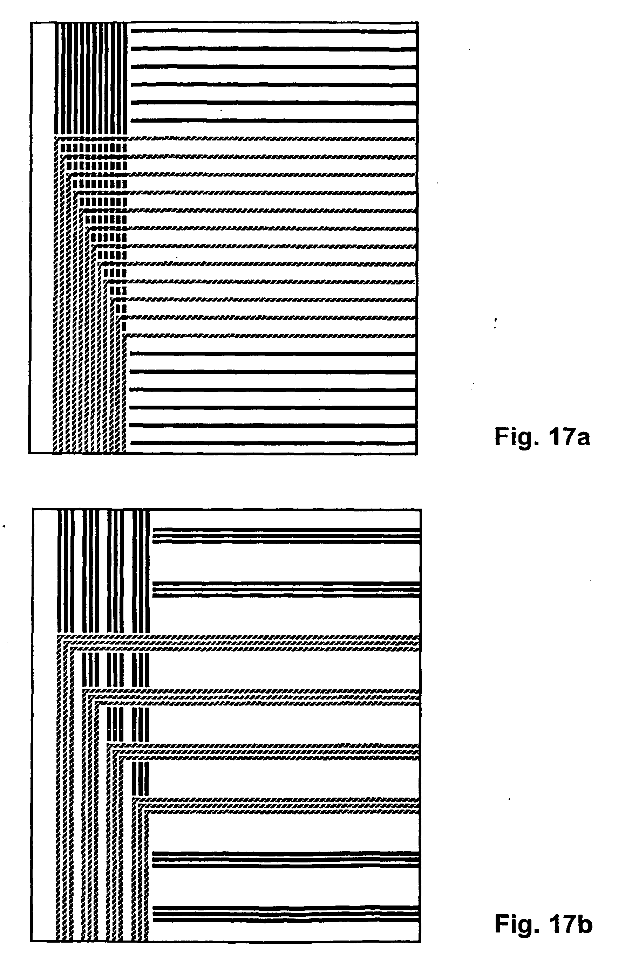

Der ganze Resonator wird vorzugsweise aus möglichst schmalen Leiterabschnitten zusammengebaut (Fig. 17a), d.h. so schmal wie es die lithografische Herstellungsmethode erlaubt, wobei diese Leiterabschnitte auch gebündelt angeordnet werden können (Fig. 17b, 16c, 16d).

Dadurch erreicht man, dass die Magnetisierungsströme im Supraleiter und die von ihnen erzeugten Feldstörungen im aktiven Messbereich möglichst klein werden.

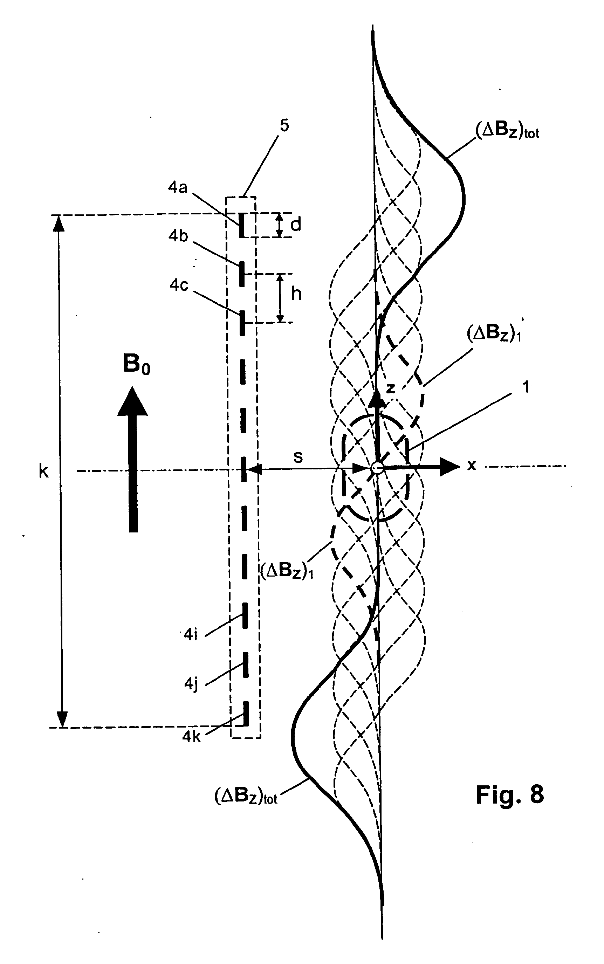

Leiterabschnitte, die horizontal orientiert, nicht gebündelt und zudem periodisch kontinuierlich in z-Richtung angeordnet sind (Fig. 17a), besitzen eine höhere Periodizität in z-Richtung, als wenn die gleichen Leiterabschnitte gebündelt werden (Fig. 17b). Die Magnetisierung des Supraleiters erzeugt deshalb im ersten Fall eine kleinere Feldstörung im aktiven Messbereich als im zweiten Fall (vergleiche dazu auch Fig. 8).

Die Bündelung der einzelnen Leiterabschnitte kann aber aus konstruktiven Gründen trotzdem vorteilhaft sein, insbesondere beim Aufbau des kapazitiven Anteils des HF-Resonators.

Im weiteren Verlauf der Beschreibung werden die Begriffe **transversales Feld** und **longitudinales Feld** sowie **NMR-Resonator, HF-Empfangsspulenanordnung** und **HF-Resonator** mehrfach vorkommen und sollen deshalb an dieser Stelle genauer definiert werden:

■ Ein transversales Feld soll ein Feld darstellen, das senkrecht zum statischen Magnetfeld $B_0$ orientiert ist, ein longitudinales ein solches, das parallel zu $B_0$ steht.

■ Ein NMR-Resonator stellt die komplette Resonator-Anordnung dar. Er setzt sich zusammen aus einer oder mehreren, vorzugsweise 2 oder 4 HF-Empfangsspulenanordnungen, die um das Messvolumen herum angeordnet sind und HF-mäßig miteinander koppeln. Die HF-Empfangsspulenanordnung ihrerseits besteht aus dem HF-Resonator und der Kompensations-Anordnung, wobei der HF-Resonator im Wesentlichen den HF-Strom tragenden Teil der HF-Empfangsspulenanordnung darstellt.

Unter Berücksichtigung der vorangegangenen Erklärungen lassen sich nachfolgend verschiedene Ausführungsformen definieren.

Besonders bevorzugt ist eine Ausführungsform der erfindungsgemäßen HF-Empfangsspulenanordnung, die sich dadurch auszeichnet, dass jeweils alle Flächenelemente, die sich nur in ihrer z-Position unterscheiden, im wesentlichen gleich viel Supraleitermaterial enthalten. Dadurch können mit einer einfachen Maßnahme die Flächenelemente leicht so gestaltet werden, dass die gewünschten HF- sowie magnetischen Eigenschaften annähernd erreicht werden.

Je kleiner die Strukturelemente der supraleitenden Struktur sind, desto feiner kann die Gesamtfläche der HF-Empfangsspulenanordnung in identische kleine Flächenelemente, die möglichst identische Dipolmomente enthalten sollen, eingeteilt werden. Es ist nämlich zu beachten, dass die kleinste Dimension dieser Flächenelemente nicht kleiner als die kleinste Dimension der Strukturelemente sein darf, da sonst die Möglichkeit besteht, dass einzelne Flächenelemente überhaupt keinen Supraleiter enthalten und deshalb die Bedingung identischer Dipolmomente pro Flächenelement nicht eingehalten werden kann. Eine möglichst feine Flächeneinteilung ist jedoch erforderlich, wenn die Welligkeit des Störfeldes im aktiven Messbereich, die durch die magnetischen Dipolmomente des supraleitenden Materials in den einzelnen Flächenelementen hervorgerufen wird, möglichst klein sein soll. Eine vernünftig feine Einteilung erhält man, wenn die Gesamtzahl der Flächenelemente größer als 50, vorzugsweise größer als 200 ist.

Im Wesentlichen kommt es jedoch bei dieser Einteilung nur auf die Anzahl der identischen Flächenelemente an, die sich nur durch ihre z-Position unterscheiden, d.h. auf Streifen liegen, die parallel zur z-Achse orientiert sind. Diese Anzahl sollte größer als 20, vorteilhafterweise größer als 50 sein.

Besonders bevorzugt ist auch eine Ausführungsform der erfindungsgemäßen HF-Empfangsspulenanordnung, bei der die supraleitfähigen Leiterstrukturen der Kompensations-Anordnung den HF-Resonator beidseits jeweils um mindestens die halbe, vorzugsweise etwa die zweifache Ausdehnung des HF-Resonators in z-Richtung überragen. Dadurch rücken die in z-Richtung vorhandenen Randbereiche der Kompensations-Anordnung, die für die Störeinflüsse im aktiven Messbereich hauptsächlich verantwortlich sind, möglichst weit räumlich vom aktiven Messbereich weg und können diesen nicht mehr signifikant beeinflussen.

Zur Optimierung des Füllfaktors werden NMR-Resonatoren meistens aus mehreren HF-Empfangsspulenanordnungen zusammengesetzt. Bei einer vorteilhaften Ausführungsform der Erfindung enthält daher der NMR-Resonator mehrere gekoppelte HF-Empfangsspulenanordnungen, vorzugsweise 2 oder 4, auf unterschiedlichen Teilflächen der Fläche, die in Flächenelemente eingeteilt werden kann, welche sich lediglich in ihrer z-Position unterscheiden.

Eine geometrisch und herstellungstechnisch besonders einfache Ausgestaltung der Erfindung ergibt sich dadurch, dass die supraleitfähigen, induktiv und zum Teil auch kapazitiv wirkenden Leiterstrukturen des oder der HF-Resonatoren und die supraleitfähigen Leiterstrukturen der Kompensations-Anordnung(en) auf ebenen Substratelementen aufgebracht sind, die untereinander und zur z-Achse parallel angeordnet sind.

Ganz besonders einfach in der Herstellung ist eine Ausführungsform der erfindungsgemäßen HF-Empfangsspulenanordnung, bei der die supraleitfähigen, induktiv und zum Teil auch kapazitiv wirkenden Leiterstrukturen des HF-Resonators und die supraleitfähigen Leiterstrukturen der zugehörigen Kompensations-Anordnung in derselben Ebene angeordnet sind. Diese und die vorhergehende Ausführungsform funktionieren im Allgemeinen dann optimal, wenn der Arbeitspunkt im linearen Bereich der Magnetisierungskurve bleibt, d.h. wenn die Magnetisierung des Supraleiters nicht zu groß ist. Bei speziell ausgesuchten, z.B. zig-zag-förmigen Leiterstrukturen ist jedoch auch eine optimale Funktionsweise außerhalb des linearen Bereichs möglich.

Eine alternative Ausführungsform zeichnet sich dadurch aus, dass die supraleitfähigen Strukturen des HF-Resonators und der zugehörigen Kompensationsanordnung in zwei oder mehreren ebenen Teilflächen liegen, die parallel zueinander angeordnet sind, wobei in der ersten Teilfläche die supraleitfähigen, induktiv und zum Teil auch kapazitiv wirkenden Leiterstrukturen des HF-Resonators sowie Teile der zugehörigen supraleitfähigen Leiterstrukturen der Kompensations-Anordnung, in den weiteren Teilflächen die verbleibenden Teile der supraleitfähigen Leiterstrukturen der Kompensations-Anordnung angeordnet sind. Durch diese etwas kompliziertere Anordnung ergibt sich ein weiterer physikalischer Freiheitsgrad, mit dem eine sehr genaue Kompensation der durch den Magnetismus des Supraleiters hevorgerufenen Störeinflusse möglich ist, wobei auch dann optimale Ergebnisse erreicht werden, wenn der Arbeitspunkt außerhalb des linearen Bereichs der Magnetisierungskurve liegt.

Bei einer Weiterbildung dieser Ausführungsform betragen die Abstände zwischen den Teilflächen, gemessen in einer Richtung senkrecht zu den Teilflächen, maximal 600 μm, vorzugsweise maximal zwischen 50 und 200 μm. Diese Abstände müssen möglichst klein gehalten werden, um Fehler in der Kompensation des Magnetismus zu minimieren.

Noch höhere Füllfaktoren als bei der ebenen Anordnung sind bei einer Ausführungsform der erfindungsgemäßen HF-Empfangsspulenanordnung möglich, bei der die supraleitfähigen, induktiv und zum Teil auch kapazitiv wirkenden Leiterstrukturen des oder der HF-Resonatoren und die supraleitfähigen Leiterstrukturen der Kompensations-Anordnung (en) auf flächigen Substratelementen aufgebracht sind, die zylindrisch um die z-Richtung gekrümmt sind. Dies wird allerdings um den Preis einer wesentlich schwierigeren Herstellung ermöglicht.

Besonders bevorzugt ist eine einfache Ausführungsform der Erfindung, bei der die Leiterstrukturen der Kompensations-Anordnung und des HF-Resonators auf derselben Teilfläche der Fläche, die in Flächenelemente eingeteilt werden kann, welche sich lediglich in ihrer z-Position unterscheiden, angeordnet sind. Ausgehend von dieser Ausführungsform lassen sich eine Vielzahl von weiteren Ausführungsformen ableiten, die durch ihren einfachen Aufbau charakterisiert sind.

Bei einer weiteren besonders bevorzugten, sehr einfachen Ausführungsform der Erfindung ist zumindest ein Teil der supraleitfähigen Abschnitte der Leiterstrukturen streifenförmig achsparallel oder achssenkrecht zur z-Richtung angeordnet. Diese Ausführungsform besitzt eine einfache Geometrie und dient als Ausgangspunkt zur Herstellung von verschiedenen Z-Strukturen.

Mehr Spielraum für Variationen ermöglicht eine Ausführungsform, bei der die supraleitenden Strukturen auf den z-invarianten Flächen (= Fläche, die in Flächenelemente eingeteilt werden kann; welche sich lediglich in ihrer z-Position unterscheiden) aus verschiedenen geometrischen Formen zusammengesetzt sind, z.B. aus Streifen verschiedener Orientierung und Breite sowie aus Rechtecken, Kreisen, Trapezen, etc. Dadurch ergibt sich eine erhöhte Flexibilität im Entwurf der Gesamtgeometrie, so dass die Optimierung der Fehlerkompensation noch besser erreicht werden kann.

Eine sehr zweckmäßige Z-Struktur, die einzeln oder mehrfach in einer erfindungsgemäßen HF-Empfangsspulenanordnung verwendet werden kann, besteht aus identischen, schmalen supraleitenden Strukturelementen, die aus einem einzelnen Leiter oder aus in Gruppen angeordneten Leitern aufgebaut sind, welche eng aufeinander folgend und periodisch kontinuierlich in z-Richtung angeordnet sind, wobei der Abstand benachbarter Strukturelemente klein gegenüber dem Abstand zum Zentrum des Untersuchungsvolumens ist.

Eine weitere sehr zweckmäßige Z-Struktur, die einzeln oder mehrfach in einer erfindungsgemäßen HF-Empfangsspulenanordnung verwendet werden kann, besteht aus Strukturelementen, die aus einem einzelnen Leiter oder aus in Gruppen angeordneten Leitern aufgebaut sind, wobei die Leiterabschnitte parallel zur z-Achse ausgerichtet sind und gleiche oder unterschiedliche Abstände zueinander haben.

Eine alternative Ausführungsform der Z-Struktur, die einzeln oder mehrfach in einer erfindungsgemäßen HF-Empfangsspulenanordnung verwendet werden kann, zeichnet sich dadurch aus, dass diese in mehrere, vorzugsweise rechteckige Teilbereiche eingeteilt wird, deren Breite gleich der Breite der Z-Struktur ist, und dass diese Teilbereiche durch gerade supraleitende Streifen gefüllt werden, die um einen gewünschten Winkel zur z-Achse geneigt sind, wobei dieser Winkel innerhalb eines Teilbereiches entweder positiv oder negativ ist, und dass die geneigten Streifen innerhalb eines Teilbereiches eng aufeinander folgend und periodisch kontinuierlich in z-Richtung angeordnet sind, wobei der Abstand benachbarter Streifen klein gegenüber dem Abstand zum Zentrum des Untersuchungsvolumens ist, und dass die geneigten Streifen an den Grenzlinien zwischen den Teilbereichen kontinuierlich ineinander übergehen. Diese Z-Struktur ist zwar in seinem Aufbau etwas komplizierter, hat aber den Vorteil, dass sie auf einer einzigen Fläche liegt und auch dann eine einwandfreie Kompensation liefert, wenn der Supraleiter so stark magnetisiert ist, dass sein Arbeitspunkt außerhalb des linearen Bereichs der Magnetisierungskurve liegt.

Besonders bevorzugt ist eine Ausführungsform der erfindungsgemäßen HF-Empfangsspulenanordnung, bei der die supraleitfähigen Leiterstrukturen, die nicht zum HF-Resonator gehören, eine Anzahl von schmalen Unterbrüchen enthalten, die über Teile oder die ganze Länge der einzelnen supraleitenden Leiterabschnitte verteilt sind. Damit wird eine erheblich bessere HF-Entkopplung zwischen dem HF-Resonator und der Kompensations-Anordnung erreicht, weil die in der Regel entstehenden Wirbelströme in den Leiterstrukturen durch die Unterbrüche besonders gering gehalten bzw. unterdrückt werden.

Bei einer weiteren Ausführungsform der Erfindung wird die Erzeugung des HF-Resonators aus den gewünschten Bereichen der Z-Strukturen dadurch erreicht, dass innerhalb von kleinen Flächenelementen der Z-Strukturen der Supraleiter oder Teile davon gedreht oder verschoben werden, und/oder dass schmale Abstände zwischen den Leitern supraleitend verbunden werden, und/oder dass schmale Unterbrüche in den Leitern angebracht werden, und/oder dass schräge und zickzackförmige Z-Strukturen verwendet werden, und/oder dass die Z-Strukturen auf zwei oder mehreren Teilflächen verteilt werden.

Eine ganz konkrete, besonders bevorzugte Ausführungsform, welche einen recht einfachen geometrischen Aufbau aufweist, zeichnet sich dadurch aus, dass die HF-Empfansspulenanordnung aus drei Z-Strukturen aufgebaut ist, nämlich links und rechts je eine mit vertikalen und dazwischen eine mit horizontalen geraden Streifen.

Andere Möglichkeiten der geometrischen Anordnung ergeben sich bei Ausführungsformen, bei denen die HF-Empfangsspulenanordnung aus drei Z-Strukturen aufgebaut ist, nämlich links und rechts je eine mit schrägen, teilweise zickzack-förmigen, und dazwischen eine mit in z-Richtung periodisch angeordneten Querstreifen. Diese Ausführungsform ist zwar in seinem Aufbau etwas komplizierter, hat aber den Vorteil, dass sie auf einer einzigen Fläche liegt und auch dann eine einwandfreie Kompensation liefert, wenn der Supraleiter so stark magnetisiert ist, dass sein Arbeitspunkt außerhalb des linearen Bereichs der Magnetisierungskurve liegt.

Eine sehr genaue Kompensation mit vielen Variationsmöglichkeiten liefert eine weitere Ausführungsform der Erfindung, bei der die ganze HF-Empfangsspulenanordnung in zwei Ebenen angeordnet und aus drei Z-Strukturen zusammengesetzt ist, nämlich aus einer ersten und zweiten mit parallel zur z-Achse sowie einer dritten mit in z periodisch und quer zur z-Achse angeordneten Streifen, wobei die dritte Z-Struktur über den beiden ersten, die einen bestimmten Abstand zueinander haben, positioniert ist und diese genau überdeckt, und wobei die Zusammensetzung des HF-Resonators und der Kompensationsstruktur dadurch erfolgt, dass die drei Z-Strukturen teilweise zerlegt und auf zwei separaten Teilflächen, die zu einem oder zwei Substraten gehören, verteilt werden, wobei die erste Teilfläche den ganzen HF-Resonator mit dem Hauptanteil der Kompensations-Struktur, und die zweite Teilfläche den Restanteil der Kompensations-Struktur enthält, und dass die so entstandenen Strukturen auf den beiden Teilflächen derart aufeinander positioniert werden, dass die Summe ihrer Strukturen wieder gleich der Summe der ursprünglichen drei Z-Strukturen ist, und dass dadurch ein funktionsfähiger NMR-Resonator entsteht.

Zumindest Teile der supraleitfähigen Leiterstrukturen können bei weiteren bevorzugten Ausführungsformen der Erfindung einen Hochtemperatursupraleiter(= HTS)-Material enthalten.
Leiter aus HTS-Material, die im Epitaxialverfahren hergestellt sind, besitzen im Temperaturbereich von ca. 4.2 K bis 30 K, der bei supraleitenden NMR-Resonatoren allgemein verwendet wird, sehr hohe kritische Stromdichten bei sehr hohen Feldstärken und sind deshalb sehr geeignet zur Herstellung von NMR-Resonatoren.

Vorteilhaft schließlich ist auch eine Ausführungsform der Erfindung, bei der die supraleitfähigen Leiterstrukturen aus dünnen, vorzugsweise zwischen 0.1 und 1$\mu$m dicken Schichten aufgebaut sind, was im Rahmen der üblichen Herstellungstechnik liegt.

Weitere Vorteile ergeben sich aus den Zeichnungen und der Beschreibung. Ebenso können die vorstehend genannten und die noch weiter aufgeführten Merkmale erfindungsgemäß einzeln für sich und zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in Zeichnungen dargestellt und wird anhand von Ausführungsbeispielen näher erläutert.

Fig. 1 Zeigt eine modifizierte **zweite Ausführungsform** des erfindungsgemäßen Resonators. Sie ist praktisch identisch mit der von Fig. 12b, besitzt jedoch in den zusätzlichen Leitern, die der Kompensation der Magnetisierung dienen, schmale Unterbrüche, damit die HF-Kopplung zwischen diesen Leitern und dem eigentlichen HF-Resonator, der schraffiert markiert ist, möglichst klein ist.

Fig. 2 Perspektivische Darstellung des Feldes $\Delta B$, das von einem magnetisierten supraleitenden Streifen erzeugt wird, dessen Längsachse parallel zu $B_0$ steht.

Fig. 3 Wie Fig. 2 aber in der xz-Ebene dargestellt. Die z-Komponente $(\Delta B_Z)_1$ des Feldes $\Delta B$ ist im Bereich des aktiven Messvolumens praktisch Null und tritt nur am oberen und unteren Rand des Streifens auf.

Fig. 4 Feld $\Delta B$ der Anordnung von Fig. 2, dargestellt in der xy-Ebene. Am Ort der aktiven Messprobe 1 sind starke Feldinhomogenitäten vorhanden, die durch die $\Delta B_X$- und $\Delta B_Y$-Komponenten hervorgerufen werden. Diese haben aber keinen Einfluss auf das NMR-Spektrum und können deshalb vernachlässigt werden.

Fig. 5 Perspektivische Darstellung des Feldes $\Delta B$, das von einem magnetisierten supraleitenden Streifen erzeugt wird, dessen Längsachse senkrecht zu $B_0$ steht.

Fig. 6 Wie Fig. 5, jedoch in der xz-Ebene dargestellt. Die $B_Z$-Komponente $(\Delta B_Z)_1$ des Feldes $\Delta B$ zeigt am Ort der aktiven Messprobe starke Inhomogenitäten, welche die NMR-Resonanzlinien stark beeinflussen können.

Fig. 7 Zeigt das Störfeld $\Delta B$, das durch die longitudinale Magnetisierung eines supraleitenden Streifens entsteht, der parallel zum $B_0$-Feld orientiert ist. Störfelder entstehen nur an den beiden Enden des Streifens.

Fig. 8 Anordnung aus mehreren supraleitenden Streifen 4a, 4b, 4c, ... ,4k, die auf einer Ebene parallel zu $B_0$ liegen und gleichmäßig übereinander angeordnet sind. Die $B_Z$-Komponente $(\Delta B_Z)_1$ der einzelnen Streifen überla-

gern sich und erzeugen das Feld $(\Delta B_Z)_{tot}$. Dieses ist im Bereich des aktiven Messvolumens 1 praktisch Null, und nur am oberen und unteren Ende der Anordnung sind noch $B_Z$-Komponenten vorhanden.

Fig. 9a    Supraleitender Streifen parallel zum $B_0$-Feld.

Fig. 9b    Supraleitende Leiterstruktur, die aus mehreren, gleichmäßig verteilten Streifen zusammengesetzt ist, die alle <u>parallel</u> zum $B_0$-Feld liegen.

Fig. 9c    Supraleitende Leiterstruktur, die aus mehreren, gleichmäßig verteilten Streifen zusammengesetzt ist, die alle <u>senkrecht</u> zum $B_0$-Feld liegen.

Fig. 9d    Supraleitende Leiterstruktur, die aus schräg zum $B_0$-Feld liegenden Streifen zusammengesetzt ist.

Fig. 9e    Spiegelbild der supraleitenden Leiterstruktur von Fig. 9d.

Fig. 9f    Supraleitende Leiterstruktur, die aus Abschnitten der Leiterstrukturen von Fig. 9d und seinem Spiegelbild Fig. 9e zusammengesetzt ist.

Fig. 10a    Supraleitende Leiterstruktur, die eine konstante Breite besitzt, in z-Richtung stark ausgedehnt ist und aus drei Teilstrukturen aufgebaut ist, zwei senkrechte und eine waagrechte. Mit dem schraffierten Bereich lässt sich der HF-Resonator aufbauen. Die übrigen Bereiche dienen der Kompensation der Magnetisierung, die vom HF-Resonator erzeugt wird.

Fig. 10b    Supraleitende Leiterstruktur wie in Fig. 10a, jedoch mit einer mittleren Teilstruktur, deren horizontale Streifen einen größeren Abstand zueinander haben. Man erreicht damit eine bessere HF-Durchlässigkeit in dieser Teilstruktur.

Fig. 11a    Teilausschnitt der Teilstruktur 8a in Fig. 10a. In den drei vertikalen Leiterstreifen ist jeweils ein einzelner geschlossener Strompfad dargestellt, der oben und unten abgeschnitten ist, und dessen Stromrichtung durch Pfeile angegeben ist.

Fig. 11b    Zeigt, wie die Stromkreise in den Leiterstreifen in weitere kleinere Stromkreise S1, S3, S4, S5 und S6 unterteilt werden, und wie diese im Uhrzeigersinn um 90 Grad gedreht werden, damit ein Stromkreis mit einer Ecke entsteht.

Fig. 11c    Zeigt das Resultat der Transformation von Fig. 11b.

Fig. 12a    Zeigt die **erste Ausführungsform** eines erfindungsgemäßen Resonators, der aus der schraffierten Struktur von Fig. 10a und unter Verwendung der Transformation gemäß Fig. 11b erzeugt wurde. Der Bereich, in dem der HF-Strom fließt, ist schraffiert markiert. Die gesamte Leiterstruktur erzeugt im magnetisierten Zustand praktisch keine z-Komponenteh im aktiven Messbereich!

Fig. 12b    Zeigt die **zweite Ausführungsform** eines erfindungsgemäßen Resonators, der aus der schraffierten Struktur von Fig. 10b und unter Verwendung der Transformation gemäß Fig. 11b erzeugt wurde. Der Bereich, in dem der HF-Strom fließt, ist schraffiert markiert. Die gesamte Leiterstruktur erzeugt im magnetisierten Zustand praktisch keine z-Komponenten im aktiven Messbereich!

Fig. 13    Zeigt die **dritte Ausführungsform** eines erfindungsgemäßen Resonators, der direkt aus den drei senkrechten Teilstrukturen (links, in der Mitte und rechts in Fig. 13) hervorgegangen ist, ohne dass dabei einzelne Leiterteile gedreht oder verschoben werden mussten. Es mussten lediglich einige Leiter über sehr kurze Strecken miteinander verbunden und/oder unterbrochen werden. Der Bereich, in dem der HF-Strom fließt, ist schraffiert markiert. Die gesamte Leiterstruktur erzeugt im magnetisierten Zustand praktisch keine z-Komponenten im aktiven Messbereich!

Fig. 14a    Zeigt die beiden senkrechten Leiterstrukturen, aus denen ein Teil der vierten Ausführungsform eines erfindungsgemäßen Resonators hergestellt wird.

Fig. 14b    Zeigt die waagrechte Leiterstruktur, aus denen ein Teil der vierten Ausführungsform eines erfindungsgemäßen Resonators hergestellt wird.

Fig. 15a    Leiterstruktur auf dem ersten Substrat der **vierten Ausführungsform** eines erfindungsgemäßen Resonators. Das Substrat enthält den HF-Resonator 7d und den Hauptanteil der Leiterstrukturen, mit denen der Magnetismus kompensiert wird.

Fig. 15b    Leiterstruktur auf dem zweiten Substrat der **vierten Ausführungsform** eines erfindungsgemäßen Resonators. Mit dieser Leiterstruktur wird der Restfehler des Magnetismus kompensiert, der auf dem ersten Substrat aus technischen Gründen nicht kompensiert werden konnte.

Fig. 16a    Teilausschnitt aus Fig. 14a. Jeweils drei einzelne Leiter sind zu einem Bündel zusammengefasst und stellen eine der möglichen Ausführungsformen dar.

Fig. 16b    Teilausschnitt aus Fig. 14b. Jeweils drei einzelne Leiter sind zu einem Bündel zusammengefasst und stellen eine der möglichen Ausführungsformen dar.

Fig. 16c    Teilausschnitt aus Fig. 15a. Jeweils drei einzelne Leiter sind zu einem Bündel zusammengefasst und stellen eine der möglichen Ausführungsformen dar.

Fig. 16d    Teilausschnitt aus Fig. 15b. Jeweils drei einzelne Leiter sind zu einem Bündel zusammengefasst und stellen eine der möglichen Ausführungsformen dar.

Fig. 17a    Teil eines bevorzugten NMR-Resonators, bei dem die einzelnen Leiter ungebündelt sind. Der schraffierte Bereich gehört zum HF-Resonator.

Fig. 17b    Teil eines NMR-Resonators, bei dem drei einzelne Leiter zu einem Bündel zusammengefasst wurden. Der schraffierte Bereich gehört zum HF-Resonator.

Es folgen nun weitere Erklärungen zur Funktionsweise der erfindungsgemäßen Ausführungsformen.

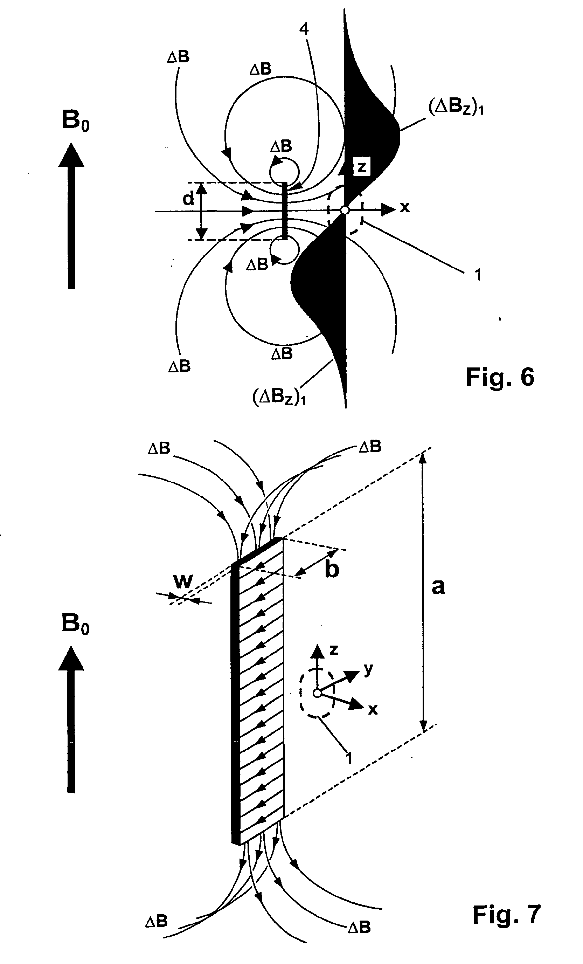

Ein supraleitender Streifen, der exakt parallel zum $B_0$-Feld orientiert ist und nie einem anderen Feld ausgesetzt war, besitzt nur eine **longitudinale Magnetisierung,** wie sie in Fig. 7 dargestellt ist. $B_z$-Komponenten entstehen nur an den beiden Enden des Streifens und sind im mittleren Bereich des Streifens vernachlässigbar klein.

Die longitudinale Magnetisierung kann durch eng anliegende geschlossene Stromkreise dargestellt werden, welche den dünnen supraleitenden Streifen, der einen rechteckigen Querschnitt besitzt, umschließen. Die Länge und Breite des rechteckigen Querschnitts ist gleich der Breite b bzw. der Dicke w des Streifens. Da die Dicke w des Supraleiters extrem klein ist (ca. 0.1-1 μm), ist auch die Querschnittsfläche (b·w) extrem klein und das erzeugte Störfeld deshalb vernachlässigbar klein.

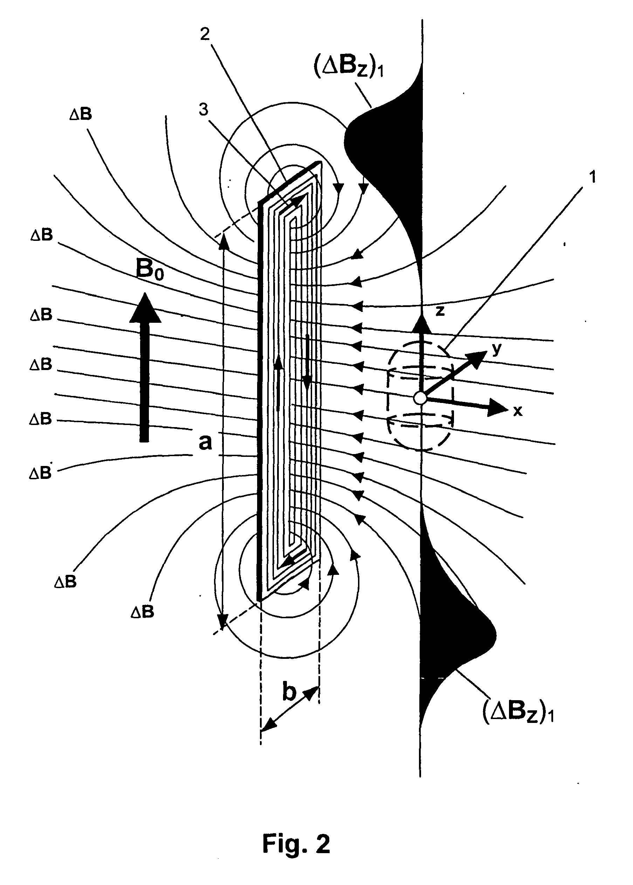

Wenn der Supraleiter nur eine longitudinale Magnetisierung besitzen würde, könnte man die Magnetisierungsprobleme bei NMR-Anwendungen vernachlässigen. Nun ist es aber so, dass bei geringsten Neigungen des Streifens gegenüber dem $B_0$-Feld (weniger als 0.1 Grad genügen bereits, da das $B_0$-Feld sehr stark ist!), der Supraleiter eine **transversale Magnetisierung** erzeugt. Diese kann durch geschlossene Stromkreise dargestellt werden, die auf der Oberfläche des supraleitenden Streifens fließen (Fig. 2), und die den veränderten magnetischen Fluss durch den Supraleiter zu kompensieren versuchen. Diese Kompensation funktioniert übrigens nur solange exakt, bis die Ströme in den Stromkreisen jeweils den kritischen Strom erreicht haben, d.h. den größtmöglichen supraleitenden Strom im Supraleiter.

Da die geschlossenen Stromkreise der transversalen Magnetisierung viel größere Flächen zur Verfügung haben als dies bei der longitudinalen Magnetisierung der Fall ist, kann auch ihr Einfluss auf das NMR-Spektrum um Größenordnungen stärker sein. Ziel der vorliegenden Erfindung ist es deshalb, den Einfluss dieser **transversalen Magnetisierung** auf die $B_0$- Homogenität im aktiven Messbereich möglichst klein zu halten. Wenn also im Weiteren von der Magnetisierung des Supraleiters gesprochen wird, ist die transversale Magnetisierung gemeint.

Es sind hauptsächlich sieben Erkenntnisse, die zur vorliegenden Erfindung geführt haben und in der Folge benützt werden:

**1. Es müssen nur die Feldkomponenten parallel zum statischen Feld $B_0$ berücksichtigt werden.**

Es ist bekannt, dass in der NMR-Spektroskopie die Resonanzfrequenz vom Absolutbetrag des Magnetfeldes am Ort der Messprobe abhängig ist:

$$|B|^2 = (B_0 + \Delta B_Z)^2 + \Delta B_X^2 + \Delta B_Y^2 = (B_0 + B_Z)^2 + \Delta B_{XY}^2$$

Solange die Störkomponenten $\Delta B_x$, $\Delta B_y$, $\Delta B_z$ klein gegenüber dem statischen Magnetfeld $B_0$ sind, erhält man für die relative Homogenität folgende Näherung (die z-Achse wird parallel zu $B_0$ angenommen):

$$|B|/B_0 \approx 1 + \Delta B_Z/B_0 + \tfrac{1}{2}\cdot(\Delta B_{XY}/B_0)^2$$

Man erkennt sofort, dass nur die Komponente $\Delta B_Z$, die parallel zum Feld $B_0$ steht, einen starken Einfluss auf die relative Homogenität hat. Die Komponente $\Delta B_{XY}$ hingegen, die senkrecht zu $B_0$ steht, besitzt einen um Größenordnungen kleineren Einfluss.

In der hochauflösenden NMR darf der relative Feldfehler ($\Delta B_Z/B_0 + \tfrac{1}{2}\cdot(\Delta B_{XY}/B_0)^2$) in der Größenordnung von $10^{-10}$ bis $10^{-11}$ liegen, und das führt für $\Delta B_Z/B_0$ und $\Delta B_{XY}/B_0$ zu den folgenden noch tolerierbaren Werten:

$$\Delta B_Z/B_0 < 10^{-10} \text{ bis } 10^{-11}$$

$$\Delta B_{XY}/B_0 < 10^{-5} \text{ bis } 10^{-6}$$

Die Störkomponente $\Delta B_Z$, die durch die Magnetisierung des Supraleiters erzeugt wird und parallel zu $B_0$ steht, hat somit einen um ca. fünf Größenordnungen stärkeren Einfluss auf das NMR-Spektrum als die Komponente $\Delta B_{XY}$, die senkrecht zu $B_0$ steht.

Da für NMR-Resonatoren im Allgemeinen nur sehr dünne Schichten von supraleitendem Material verwendet werden, lässt sich die geforderte Bedingung ($\Delta B_{XY}/B_0 < 10^{-5}$ bis $10^{-6}$) sehr leicht erfüllen. Zusammenfassend bedeutet dies, dass bei Homogenitätsbetrachtungen nur die z-Komponente $\Delta B_Z$ des Störfeldes berücksichtigt werden muss! Die beiden anderen Komponenten $\Delta B_X$ und $\Delta B_Y$ dürfen bedenkenlos vernachlässigt werden.

**2. Ströme parallel zur z-Achse können vernachlässigt werden.**

Ströme, die parallel zur z-Achse, d.h. parallel zum statischen Magnetfeld $B_0$ fließen, können gemäß den Maxwellgleichungen keine $B_Z$-Komponenten erzeugen und dürfen deshalb vernachlässigt werden.

Ströme hingegen, die senkrecht zum statischen Magnetfeld gerichtet sind, z.B. solche, die auf einer x-y-Ebene fließen, können $B_Z$-Komponenten erzeugen und müssen deshalb berücksichtigt werden.

**3. Supraleitende Streifen parallel zum statischen Magnetfeld $B_0$ erzeugen nur an ihren beiden Enden $B_z$-Komponenten.**

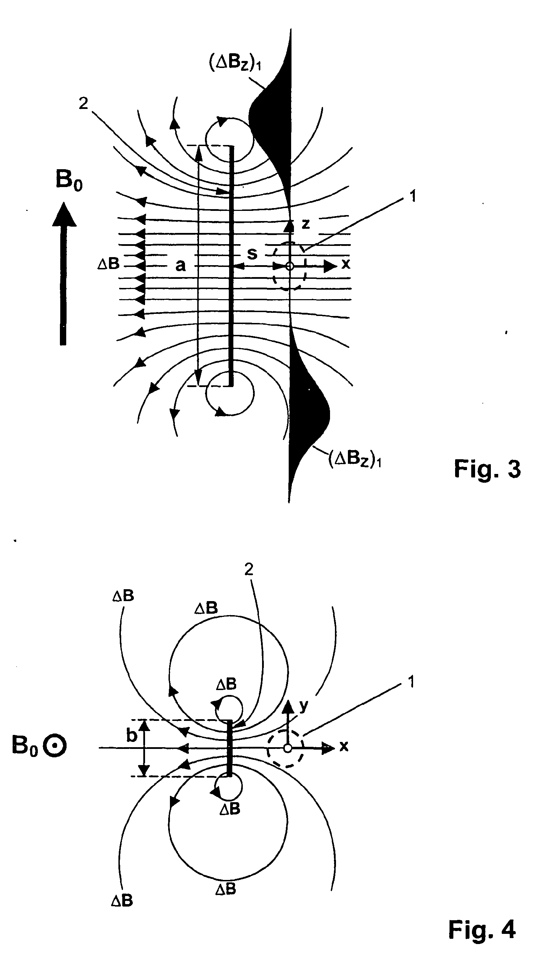

Ein sehr dünner supraleitender Streifen mit der Länge a, der Breite b und der Dicke w, wobei b << a und w << b, und bei dem die Längsachse parallel zur z-Achse steht, besitzt nur an den beiden Enden des Streifens Ströme, die senkrecht zur z-Achse fließen und dadurch $B_Z$-Komponenten erzeugen (Fig.2 und 3). Wenn also der Streifen genügend lange ist, d.h. wenn a groß gegenüber dem Abstand s (Fig. 3) zwischen Streifen und Zentrum des Messvolumens ist, dann sind die Enden weit weg vom aktiven Messvolumen und können deshalb die $B_Z$-Homogenität im Messvolumen praktisch nicht mehr beeinflussen. Der Streifen bleibt zwar magnetisiert, kann sogar bis zu seinem maximalen Wert, der durch den kritischen Strom des Supraleiters gegeben ist, magnetisiert sein, und trotzdem ist sein Einfluss auf die $B_Z$-Homogenität kaum spürbar.

**4. Supraleitende Streifen, die entweder senkrecht oder schräg zum statischen Magnetfeld $B_0$ orientiert sind, sich aber in Richtung des $B_0$-Feldes über eine längere Strecke periodisch kontinuierlich wiederholen, besitzen eine in z-Richtung langgezogene, homogene Struktur, die nur an ihren beiden Enden $B_z$-Komponenten erzeugen.**

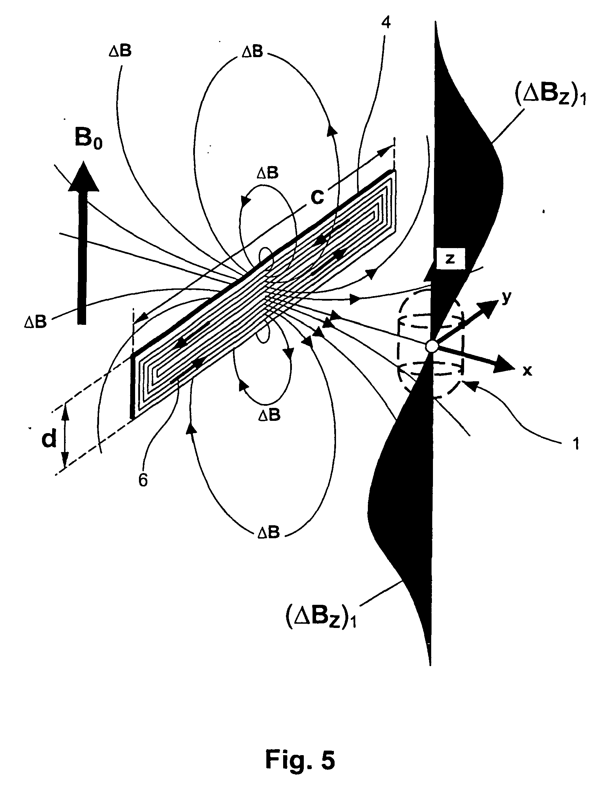

Ein supraleitender Streifen mit der Länge c und der Breite d, wobei d klein gegenüber c ist, und mit einer Längsachse senkrecht zur z-Achse, besitzt wesentliche Anteile an Strömen, die senkrecht zur z-Achse fließen und dadurch $B_Z$-Komponenten erzeugen (Fig. 5 und 6). Diese Ströme können die $B_Z$-Homogenität im aktiven Messvolumen empfindlich stören.

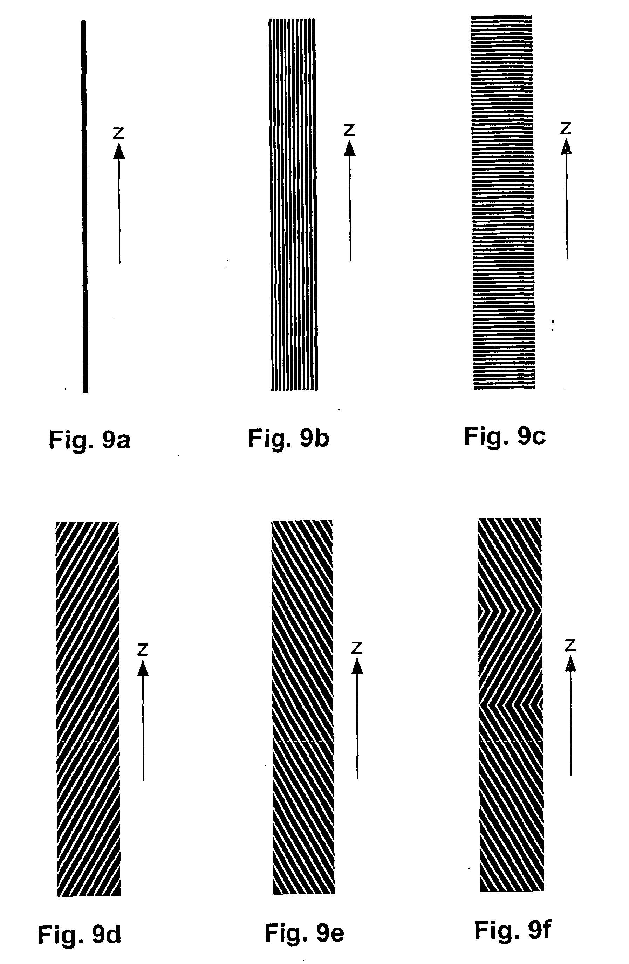

Werden jedoch sehr viele solcher Streifen gleichmäßig in z-Richtung angeordnet, so dass eine genügend lange periodisch kontinuierliche Struktur entsteht (Fig. 9c), dann sind im mittleren Bereich der Streifenstruktur praktisch keine z-Komponenten vorhanden. Fig. 8 zeigt als Beispiel eine Streifenstruktur mit 11 solcher Streifen, die auf einer Ebene parallel zur z-Achse und in gleichen Abständen übereinander angeordnet sind. Solange der Abstand h der Streifen klein gegenüber dem Abstand s zwischen der Streifenstruktur und dem Zentrum des aktiven Messvolumens ist, und solange die Länge k der Streifenstruktur in z-Richtung groß gegenüber dem Abstand s ist, kompensieren sich die von den einzelnen Streifen erzeugten z-Inhomogenitäten im Bereich des aktiven Messvolumens gegenseitig praktisch zu Null, so dass dort ein sehr homogener Bereich mit nur einer geringfügigen Welligkeit entsteht. Größere $B_Z$-Inhomogenitäten sind nur noch am oberen und unteren Ende der Streifenstruktur vorhanden.

Diese Erkenntnis gilt nicht nur für Streifen, die senkrecht zur z-Achse orientiert sind (Fig. 9c), sondern auch für solche, die schräg zur z-Achse stehen (Fig. 9d, 9e), oder auch für beliebige andere, in z-Richtung periodische Strukturen.

**5. Wenn supraleitende Teile innerhalb von kleinen Flächenelementen gedreht oder verschoben werden, ändert sich das von ihnen erzeugte Magnetfeld am Ort des aktiven Messbereichs praktisch nicht.**

Eine beliebige supraleitende Struktur auf einem flächigen Substrat kann in ein Netz von gleichen quadratischen Flächenelementen eingeteilt werden, deren Seitenlänge klein gegenüber dem Abstand zum Zentrum des aktiven Messbereiches ist.

Der Supraleiter im einzelnen Flächenelement soll magnetisiert sein und eine transversale Magnetisierung besitzen. Diese wird durch geschlossene Ringströme im Supraleiter erzeugt, und da die geometrischen Dimensionen dieser Ringströme klein gegenüber dem Abstand zum Zentrum des aktiven Messbereiches sind, dürfen sie alle zusammen durch einen magnetischen Dipol ersetzt werden, den wir Ersatzdipol nennen wollen. Der Ersatzdipol erzeugt im aktiven Messbereich praktisch das gleiche Feld wie die entsprechenden Ringströme.

Der Supraleiter im einzelnen Flächenelement darf nun gedreht und verschoben werden, sogar seine geometrische Form darf verändert werden, ohne dass dadurch das Feld im aktiven Messbereich geändert wird - einzige Bedingung ist, dass der Ersatzdipol nach diesen Änderungen gleich groß geblieben ist.

**6. Der Einfluss von einzelnen, schmalen Unterbrechungen in den supraleitenden Streifen kann vernachlässigt werden.**

Einzelne Unterbrechungen in den supraleitenden Streifen haben keinen merklichen Einfluss auf die z-Homogenität im aktiven Messbereich. Eine Unterbrechung kann nämlich durch Stromschlaufen ersetzt werden, die entgegengesetzt zu den normalen Stromschlaufen im Supraleiter fließen, auf eine sehr kleine Fläche beschränkt sind, und darum nur ein sehr kleines Feld erzeugen können.

**7. Eine supraleitende Leiterstruktur und ihre Spiegelung um eine zum statischen Magnetfeld $B_0$ parallelen Ebene verhalten sich magnetisch identisch.**

Wird eine supraleitende Leiterstruktur um eine zur z-Achse parallelen Ebene gespiegelt, dann bleiben alle Winkel in Bezug zur z-Achse und somit zum $B_0$-Feld erhalten, und deshalb bleibt auch die kritische Stromdichte und die Stromverteilung im Supraleiter erhalten.

Die Leiterstrukturen von Fig. 9d und Fig. 9e sind aus diesem Grunde magnetisch identisch, und da Fig. 9f aus beiden Leiterstrukturen zusammengesetzt ist, ist auch diese magnetisch weitestgehend identisch zu Fig. 9d und Fig. 9e.

Glücklicherweise hängt das NMR-Spektrum nur von der $B_Z$-Komponente im aktiven Messbereich **(Erkenntnis 1)**, herrührend von der transversalen Magnetisierung, ab. Bei einem langen supraleitenden Streifen parallel zum $B_0$-Feld treten z-Komponenten nur an den beiden Enden des Streifens auf, im aktiven Messbereich hingegen sind diese verschwindend klein (Fig. 2). Der Grund dafür sind die Stromrichtungen in den geschlossenen Stromkreisen des Supraleiters, die im Bereich der Probe 1 parallel zum $B_0$-Feld gerichtet sind, an den Enden des Streifens jedoch quer zum $B_0$-Feld stehen. Wie weiter oben unter Erkenntnis 2 gezeigt wurde, erzeugen Ströme parallel zum $B_0$-Feld keine z-Komponenten und sind deshalb harmlos.

Fig. 4 zeigt auf eindrückliche Weise was geschehen würde, wenn das NMR-Spektrum auch von den x- und y-Komponenten der transversalen Magnetisierung abhängig wäre. Man erkennt deutlich, dass starke Inhomogenitäten im aktiven Messbereich 1 vorhanden sind, welche das NMR-Spektrum stark beeinflussen könnten. Würde uns die NMR durch die abgeschwächte Forderung, dass nur $B_Z$-Komponenten zu berücksichtigen sind, nicht großzügig entgegen kommen, wäre die vorliegende Erfindung praktisch nicht realisierbar.

Ein supraleitender Streifen, der quer zur Richtung des $B_0$-Feldes steht (Fig. 5), erzeugt grundsätzlich z-Komponenten, da ein großer Anteil der Ströme quer zur Richtung des $B_0$-Feldes fließen. Trotzdem ist es möglich, solche Streifen erfolgreich zu benützen, wie dies die **Erkenntnis 4** zeigt. Einzige Bedingung ist, dass diese Streifen sich periodisch kontinuierlich in z-Richtung wiederholen (Fig. 9c) und dass dadurch eine genügend lange Leiterstruktur in z-Richtung entsteht. Ist das der Fall, dann kompensieren sich im mittleren Bereich der Leiterstruktur, d.h. im Bereich des aktiven Messbereichs, die Felder, die durch die Querströme erzeugt werden, und nur am oberen und unteren Ende der Leiterstruktur entstehen z-Komponenten, weil dort die Kompensation nicht mehr vollständig funktioniert (Fig. 8).

**Aus diesen Erkenntnissen geht hervor**, dass Leiterstrukturen, deren Breite konstant und Länge groß gegenüber dem aktiven Messbereich ist, die eine parallel zum $B_0$-Feld orientierte Längsachse und eine in z-Richtung makroskopisch homogene Verteilung der supraleitenden Teile besitzen, nur $B_z$-Komponenten am oberen und unteren Ende der Leiterstrukturen erzeugen, aber praktisch keine im zentralen Bereich, wo sich die Messprobe befindet. Die Länge dieser Leiterstrukturen muss jedoch so groß sein, dass die an den Enden erzeugten Felder ein vernachlässigbar kleines Störfeld im aktiven Messbereich erzeugen.

Eine in z-Richtung makroskopisch homogene Verteilung der supraleitenden Teile kann dadurch erreicht werden, dass die Fläche der Leiterstruktur in ein Raster von gleichen quadratischen Flächenelementen eingeteilt wird, deren Seitenlänge klein gegenüber dem Abstand zum Zentrum des aktiven Messbereiches ist, und der Supraleiter derart auf die einzelnen Flächenelemente verteilt wird, dass die vom Supraleiter erzeugte transversale Magnetisierung in jedem Flächenelement durch möglichst gleich starke magnetische Dipole ersetzt werden kann. Dadurch können Leiterstrukturen entstehen, die z.B. aus verschiedenen geometrischen Formen zusammengesetzt sind, z.B. aus Streifen verschiedener Orientierung und Breite sowie aus Rechtecken, Kreisen, Trapezen, etc, ohne dass diese Leiterstrukturen Störfelder im aktiven Messbereich erzeugen.

Eine in z-Richtung makroskopisch homogene Verteilung der supraleitenden Teile kann auch dadurch erreicht werden, dass diese Teile aus identischen, schmalen Leiterabschnitten bestehen, die eng aufeinander folgend und periodisch kontinuierlich angeordnet sind. Dabei müssen die Leiterabschnitte so eng aufeinander folgen, dass die Welligkeit des von ihnen erzeugten Störfeldes im aktiven Messbereich vernachlässigbar klein ist. Beispiele für solche Leiterstrukturen sind in Fig. 9c, 9d und 9e dargestellt.

Die supraleitenden Teile brauchen aber nicht unbedingt alle identisch untereinander zu sein, sonder können auch mit ihren spiegelsymmetrischen Abbildungen ergänzt werden, wie dies im Beispiel Fig. 9f dargestellt ist und weiter oben in **Erkenntnis 7** näher erklärt wurde.

Zudem ist zu beachten, dass im speziellen Fall, wo die supraleitenden Teile aus schmalen geraden und parallel zum $B_0$-Feld orientierten Leiterabschnitten bestehen, diese nicht periodisch kontinuierlich aufeinander folgen müssen, sondern einen beliebigen Abstand zueinander haben dürfen, denn jeder einzelne Leiterabschnitt für sich erzeugt bereits kein $B_z$-Feld im aktiven Messbereich.

Solche Leiterstrukturen, wie sie soeben beschrieben wurden, wollen wir in Zukunft als **Z-Strukturen** bezeichnen. Die vorliegende Erfindung geht von mehreren solcher Z-Strukturen aus, die eng nebeneinander und/oder aufeinander angeordnet werden, und baut aus einem bestimmten Bereich dieser Leiterstrukturen den gewünschten HF-Resonator. Der verbleibende Teil dieser Leiterstrukturen trägt nur noch zur Kompensation des Magnetismus des Supraleiters bei und sollte im Idealfall keinen HF-Strom tragen. HF-Strom sollte nur im HF-Resonator fließen, und deshalb muss dieser möglichst gut HF-mäßig von den übrigen Leitern entkoppelt sein.

Um den HF-Resonator aus den Z-Strukturen aufzubauen werden einzelne ausgesuchte kleinflächige Leiteranteile gedreht oder verschoben gemäß **Erkenntnis 5**, sowie einzelne Leiterabschnitte miteinander verbunden oder unterbrochen.

Der restliche Teil der Z-Struktur, der nicht zum HF-Resonator gehört, lässt sich ebenfalls gemäß **Erkenntnis 5** modifizieren, wobei z.B. vertikale Leiteranordnungen in horizontale umgewandelt werden können, um dadurch die HF-Kopplung mit dem HF-Resonator zu verkleinern.

Der Vollständigkeit halber müssen noch folgende zwei Punkte erwähnt werden, die sich auf die Z-Strukturen beziehen:

1. Die Z-Strukturen müssen nicht auf einer Ebene liegen, sie können auf allen in z invarianten Flächen realisiert werden, insbesondere auch auf Zylinderflächen.

2. Die Z-Strukturen müssen zwar eine über z konstante Breite aufweisen, müssen aber nicht rechteckig sein, d.h. die beiden Abschlüsse an den Enden ihrer Längsausdehnung dürfen beliebig geformt sein, z.B. schräg oder gekrümmt. Da diese Abschlüsse weit weg vom aktiven Messbereich liegen, haben sie keinen Einfluss auf die Feldhomogenität im Messbereich.

Die beschriebenen Ideen lassen viele Realisierungsmöglichkeiten zu, von denen wir nur einige beschreiben wollen. Alle nun folgenden Ausführungsformen gehen von nur drei Z-Strukturen aus, zwei mit vertikalen (zur z-Achse parallelen) oder schrägen Leiterabschnitten und eine mit waagrechten (zur z-Achse senkrechten) Leiterabschnitten.

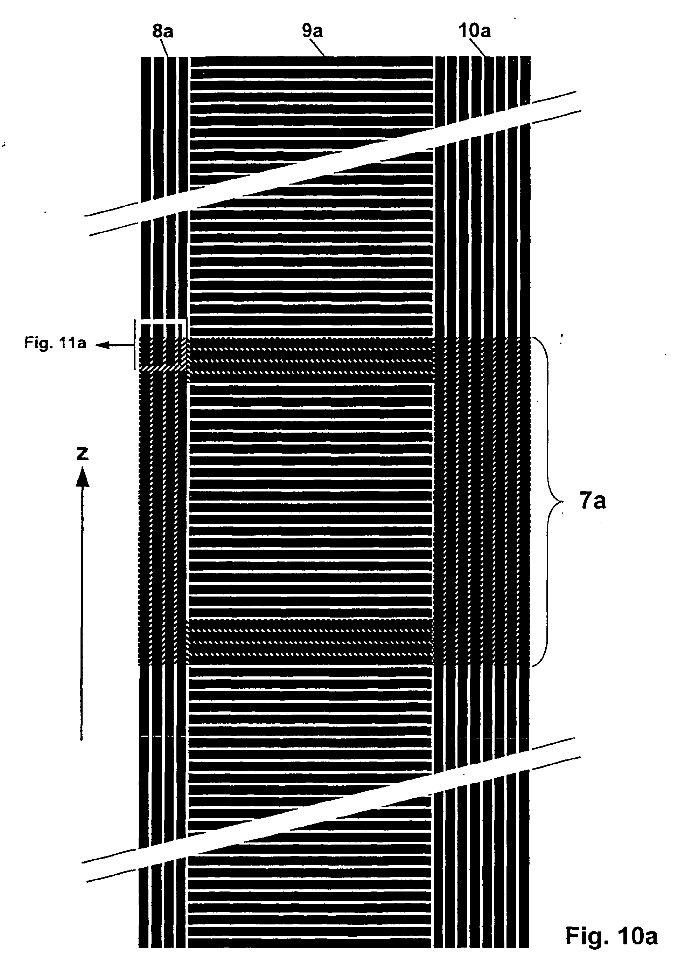

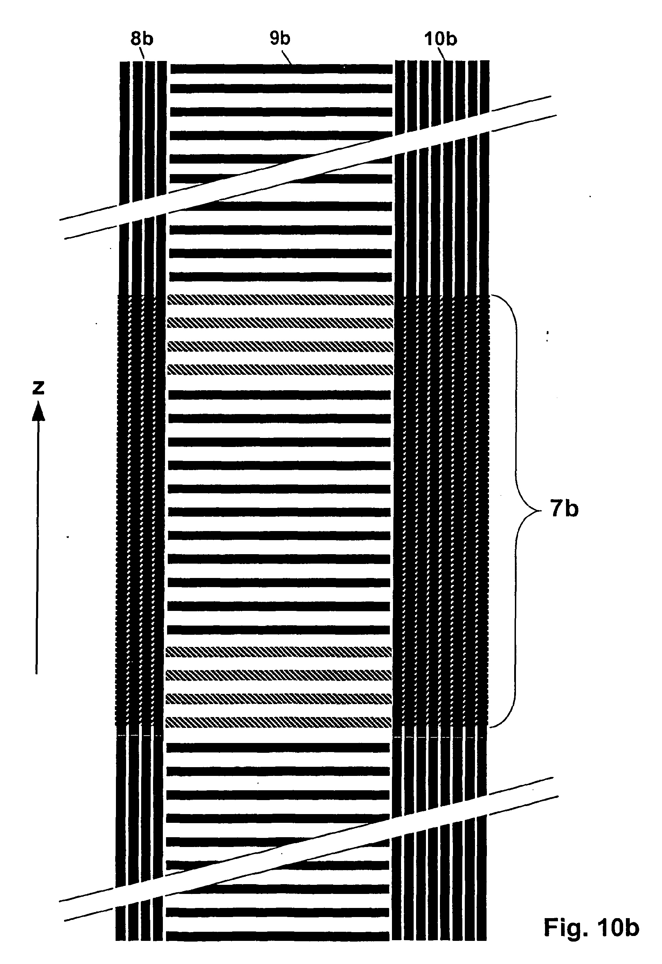

In der **ersten Ausführungsform** der erfinderischen Idee besteht die erste Z-Struktur aus Streifen parallel zum $B_0$-Feld, gefolgt von einer zweiten mit Streifen senkrecht zum $B_0$-Feld, und diese wiederum gefolgt von einer dritten mit Streifen parallel zum $B_0$-Feld. Ein Beispiel dazu ist in Fig. 10a dargestellt, wobei die drei Z-Strukturen so gewählt sind, dass daraus ein HF-Resonator vom Typ Fig. 10a im Patent [6] hergestellt werden kann. Der Bereich der Z-Strukturen, aus denen der HF-Resonator entstehen soll, ist in Fig. 10a schraffiert dargestellt (Bereich 7a). Aus der linken Z-Struktur 8a, die am nächsten zur Messprobe liegt, werden die vorwiegend felderzeugenden Leiter hergestellt, aus der mittleren 9a die oberen und unteren Querleiter, und aus der rechten 10a die kapazitiven Anteile. Die rechte Leiterstruktur 10a besitzt doppelt so viele Leiter wie die linke Leiterstruktur 8a, damit die kapazitiven Anteile erzeugt werden können.

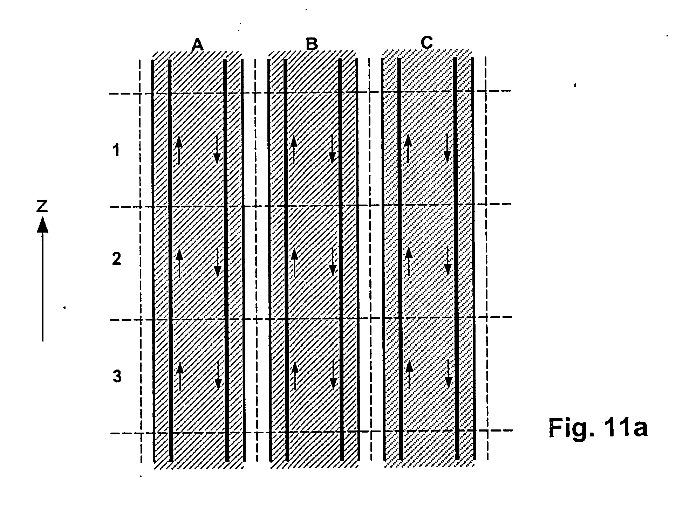

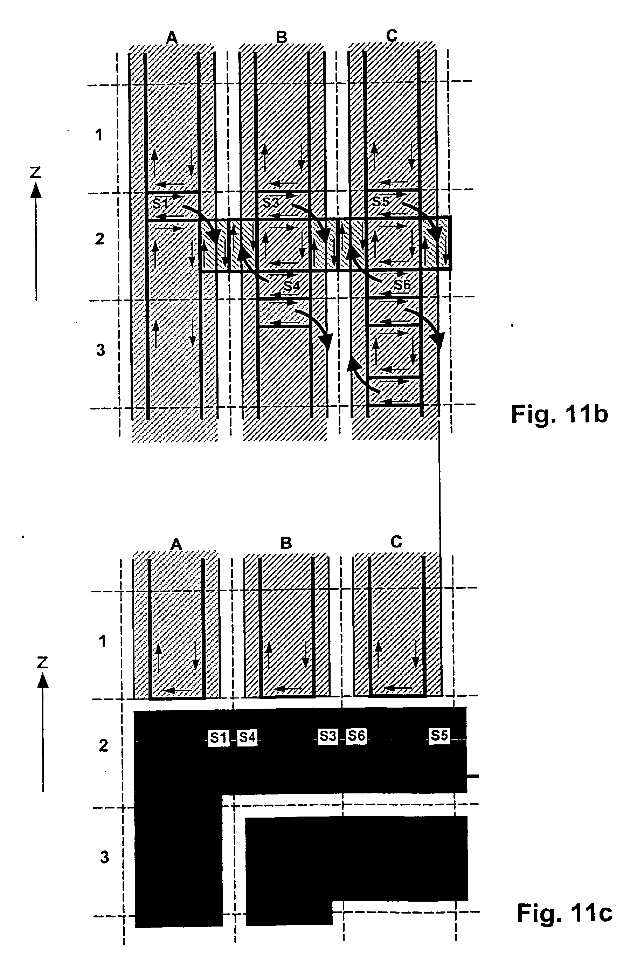

Die Problematik liegt in der Erzeugung der Ecken des HF-Resonators, die sich in den Leiterstrukturen 8a und 10a (Fig. 10a) befinden, und gelöst wird dieses Problem dadurch, dass bestimmte Bereiche der einzelnen Strompfade im Supraleiter durch kleine geschlossene Strompfade S1, S3, S4, S5 und S6 (Fig. 11 b) ersetzt werden, wobei an den Berührungslinien zwischen benachbarten Strompfaden die Ströme entgegengesetzt gleich sein müssen. Da die Dimensionen dieser kleinen Strompfade den Voraussetzungen der **Erkenntnis 5** entsprechen, dürfen sie innerhalb der Flächenelemente A2, B2 und C2 (Fig. 11b) gedreht oder verschoben werden, ohne dass dabei das $B_0$-Feld im aktiven Messbereich beeinflusst wird. Nachfolgend sollen die einzelnen Schritte näher beschrieben werden, die zur Lösung des Problems führen.

Fig. 11a ist ein Ausschnitt der Leiterstruktur 8a und besteht aus drei senkrechten supraleitenden Streifen, auf denen jeweils ein einzelner geschlossener Strompfad dargestellt ist. Dieser ist oben und unten abgeschnitten, und die Richtung, in welcher der Strom fließt, ist mit Pfeilen markiert.

Die fünf Strompfade S1, S3, S4, S5 und S6 werden jeweils im Uhrzeigersinn um 90 Grad um das Zentrum des zugehörigen Flächenelementes gedreht (Fig. 11b), und dasselbe wird auch mit den kleinen Strompfaden in den Flächenelementen B3 und C3 durchgeführt. Es resultieren daraus Strompfade mit jeweils einer Ecke, wie in Fig. 11 c dargestellt.

Diese Transformation wurde an einem einzelnen Strompfad innerhalb des jeweiligen supraleitenden Streifens von Fig. 11a erklärt, sie gilt jedoch für alle möglichen Strompfade, die in den jeweiligen Streifen fließen können, und erst wenn die beschriebene Transformation an allen möglichen Strompfaden innerhalb der jeweiligen Streifen ausgeführt wurde, erhält man die in Fig. 11c dargestellte supraleitende Struktur.

Nach Erzeugung aller Ecken gemäss der beschriebenen Transformation erhält man die gesamte Struktur des HF-Resonators, wie sie in Fig. 12a als schraffierte Fläche dargestellt ist. Diese ist magnetisch praktisch identisch zu der hell markierten Fläche von Fig. 10a und erzeugt deshalb keine störenden $B_z$-Komponenten im aktiven Messbereich.

Die Leiterstruktur von Fig. 12a besitzt den Nachteil, dass die HF-Feldlinien des HF-Resonators die Struktur 9a von dicht aneinander liegenden horizontalen Streifen durchstoßen müssen und daran stark behindert werden, weil nur geringe Zwischenräume vorhanden sind, durch welche die Feldlinien ihren Weg finden können. Insbesondere die horizontalen Streifen, die vom HF-Resonator umschlossen werden, müssen die größte Konzentration an Feldlinien durchlassen und bilden deshalb das größte Hindernis.

Aus diesem Grunde wurde in einer **zweiten Ausführungsform** der erfinderischen Idee die mittlere Leiterstruktur 9a von Fig. 10a durch die durchsichtigere Leiterstruktur 9b von Fig. 10b ersetzt. Nach Ausführung der bereits oben beschriebenen Transformation erhält man die Struktur von Fig. 12b, die wesentlich durchsichtiger für die HF-Feldlinien ist und deshalb bessere HF-Eigenschaften besitzt.

Prüft man die beiden oben beschriebenen Ausführungsformen auf ihre verbleibenden Fehlerquellen, dann können deren zwei angegeben werden:

1. Das Störfeld, das von außen auf den Supraleiter einwirkt, muss so klein sein, dass der Arbeitspunkt auf der Magnetisierungskurve noch im linearen Bereich liegt, d.h. dass eine lineare Beziehung zwischen Strom im Supraleiter und Störfeld herrscht. Ist dies nicht der Fall, dann muss eine evtl. vorhandene Anisotropie des Supraleiters berücksichtigt werden. Anisotropie bedeutet, dass Ströme parallel zum $B_0$-Feld eine andere kritische Stromdichte besitzen als solche senkrecht zum $B_0$-Feld, und das führt bei einer Drehung des Supraleiters zu einer anderen Stromverteilung und damit zu einem anderen integralen Stromwert im Supraleiter. Die Folge davon ist eine Änderung des $B_0$-Feldes im aktiven Messbereich, die direkt proportional zur Änderung dieses integralen Stromwertes ist.

2. Ein weiterer Fehler entsteht dadurch, dass nach der Drehung oder Verschiebung der geschlossenen Strompfade Randbereiche entstehen können, wo die Ströme sich an den Kanten einiger Flächenelemente konzentrieren (siehe Ströme an der unteren Kante der Flächenelemente A1, B1 und C1 in Fig. 11c), was natürlich in Wirklichkeit nicht möglich ist. Verteilt man diese Kantenströme wieder über eine bestimmte Fläche, wie dies aus physikalischen Gründen erforderlich ist, damit unendlich hohe Stromdichten an den Kanten vermieden werden, dann wird ein kleiner Fehler erzeugt.

**Vorteile der zweiten Ausführungsform :**

■ Es sind vielfältige Variationsmöglichkeiten der Leiterstrukturen möglich.

■ Alle Leiterstrukturen befindet sich auf einem einzelnen Substrat.

**Nachteile der zweiten Ausführungsform :**

■ Wenn eine Anisotropie des Supraleiters vorhanden ist, dann ist eine genaue Kompensation nur im linearen Bereich der Magnetisierungskurve, d.h. nur bei kleinen Störfeldern gewährleistet.
■ Die Drehung der kleinen Stromkreise führt zu kleineren Fehlern in den Randbereichen einiger supraleitenden Streifen.

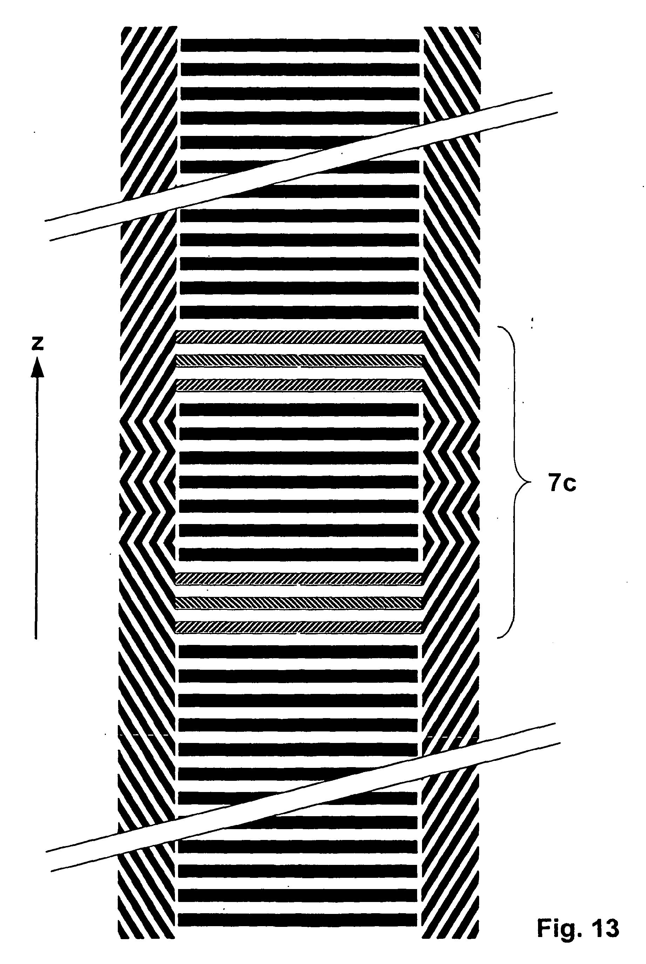

Da vor allem die Anisotropie des Supraleiters zu signifikanten Störungen führen kann, wird in einer **dritten Ausführungsform** der erfinderischen Idee eine Variante vorgestellt, die ohne Drehung oder Verschiebung von Strompfaden auskommt. Es werden wiederum drei Z-Strukturen verwendet. Die beiden äußeren sind mit schrägen Streifen gemäß Fig. 9f aufgebaut, die mittlere mit horizontalen Streifen gemäß Fig. 9c. Die beiden äußeren Leiterstrukturen besitzen den Vorteil, dass ein Teil der Leiter eine galvanisch zusammenhängende Struktur ergeben, die eine Ausdehnung in z-Richtung und zugleich Anschlussmöglichkeiten an den Rändern der beiden Leiterstrukturen möglichkeiten an den Rändern der beiden Leiterstrukturen besitzen. Diese Anschlussmöglichkeiten erlauben eine direkte Verbindung an die horizontalen Streifen der mittleren Leiterstruktur, und zwar ohne dass vorher Strompfade gedreht oder verschoben werden müssen.
Ein Beispiel dazu ist in Fig. 13 dargestellt, wobei die Leiterstrukturen so gewählt wurden, dass ein NMR-Resonator vom Typ Fig. 2c im Patent [8] erzeugt werden kann. Der HF-Resonator besitzt drei Leiterschlaufen, die aber nicht ganz geschlossen sondern jeweils durch einen schmalen Abstand unterbrochen sind, wodurch die Erzeugung des kapazitiven Anteils des Resonators ermöglicht wird. Die erste und dritte Leiterschlaufe haben den Unterbruch im unteren Querleiter, die mittlere Leiterschlaufe im oberen Querleiter. Der große Vorteil dieser dritten Ausführungsform ist ihre Unabhängigkeit von der Anisotropie des Supraleiters.

**Vorteile der dritten Ausführungsform :**

■ Die Kompensation ist unabhängig von der Anisotropie des Supraleiters.

■ Die gesamte Leiterstruktur befindet sich auf einem einzelnen Substrat.

**Nachteile der dritten Ausführungsform :**

■ Die Variationsmöglichkeiten des Resonators sind beschränkt, weil ein Teil der Leiter eine Zickzack-Struktur mit Anschlussmöglichkeiten an den Rändern der zugehörigen kompensierten Leiterstruktrur besitzen muss.

Da die Variationsmöglichkeiten bei der dritten Ausführungsform beschränkt sind, wird eine **vierte Ausführungsform** der erfinderischen Idee vorgestellt, welche eine wesentlich größere Vielfalt an Variationen erlaubt und trotzdem unabhängig von der Anisotropie des Supraleiters ist. Neu ist hier die Einführung von zwei verschiedenen Substraten, auf denen die Z-Strukturen auf geeignete Weise verteilt werden. Die beiden Substrate werden so aufeinander positioniert, dass die darauf angebrachten Leiterstrukturen nahe aufeinander zu liegen kommen und z.B. nur durch eine dünne, elektrisch isolierende Folie getrennt sind. Auf diese Weise sind alle Leiterstrukturen praktisch auf einer Ebene angeordnet.
Die beiden Substrate können aber auch so aufeinander gelegt werden, dass die Leiterstrukturen nicht direkt aufeinander zu liegen kommen sondern durch eines der beiden Substrate getrennt sind. In diesem Fall sollte jedoch das Substrat, das die Trennfunktion übernimmt, möglichst dünn sein, damit auch hier alle Leiterstrukturen praktisch auf einer einzigen Ebene liegen.

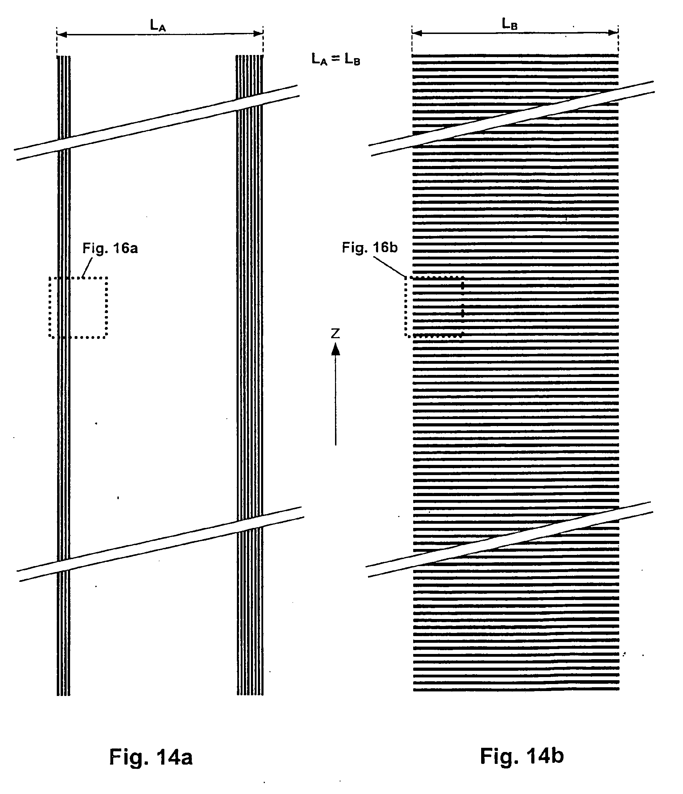

Als Beispiel soll ein NMR-Resonator vom Typ Fig. 10a im Patent [6] gebaut werden. Man geht wiederum von drei Z-Strukturen aus, nämlich eine erste und zweite vertikale gemäß Fig. 14a und einer dritten horizontalen gemäß Fig. 14b, wobei die dritte separat dargestellt ist, tatsächlich jedoch über den beiden ersten liegt und diese genau überdeckt.

Aus der ersten Leiterstruktur links in Fig. 14a, die am nächsten zur Messprobe positioniert wird, werden die vorwiegend felderzeugenden Anteile des HF-Resonators abgeleitet, aus der rechten die kapazitiven Anteile, wobei die rechte doppelt so viele Leiter wie die linke besitzt, damit der kapazitive Anteil realisiert werden kann.

Aus der dritten Z-Struktur (Fig. 14b) werden die Querverbindungen des HF-Resonators abgeleitet. Die Breite $L_B$ dieser Z-Struktur ist gleich der Breite $L_A$ der beiden Z-Strukturen von Fig. 14a, d.h. die drei Z-Strukturen überdecken sich genau.

Die drei Z-Strukturen werden nun zerlegt und derart auf die beiden Substrate verteilt, dass auf jedem einzelnen Substrat keine Leiter übereinander liegen oder sich kreuzen, und dass gesamthaft ein resonanzfähiger HF-Resonator entsteht. Das erste Substrat erhält die Struktur von Fig. 15a, d.h. den HF-Resonator sowie den Hauptanteil der Leiterstrukturen, mit denen die Magnetisierung kompensiert wird, und das zweite Substrat die Struktur von Fig. 15b, mit welcher der Restanteil der Magnetisierung kompensiert wird. Wichtig ist dabei, dass die Summe der Strukturen von Fig. 15a und 15b möglichst gleich der Summe der Z-Strukturen von Fig. 14a und 14b ist, denn nur so ist der auf den zwei Substraten aufgebaute Resonator magnetisch identisch zu den ursprünglichen drei Z-Strukturen von Fig. 14a und 14b, und von diesen wissen wir, dass sie keine $B_z$-Komponenten im aktiven Messbereich erzeugen.

**Vorteile der vierten Ausführungsform :**

■ Die Kompensation ist unabhängig von der Anisotropie des Supraleiters.

■ ■ Es sind vielfältige Variationsmöglichkeiten der Leiterstrukturen möglich.

**Nachteil der vierten Ausführungsform :**

■ Es sind zwei einzelne Substrate oder ein beidseitig beschichtetes Substrat erforderlich, deren Strukturen exakt aufeinander positioniert werden müssen.

Zusammenfassend sollen alle Prozeduren aufgeführt werden, mit denen der HF-Resonator aus den gewünschten Bereichen der Z-Strukturen gebaut werden kann. Die nachfolgend aufgeführten Prozeduren können einzeln, in Gruppen oder alle zugleich angewendet werden:

1. Drehen oder verschieben von supraleitenden Teilen innerhalb von kleinen Flächenelementen.
2. Überbrücken von schmalen Zwischenräumen mit einem Supraleiter.
3. Anbringen von schmalen Unterbrüchen
4. Verwenden von Z-Strukturen, die schräge und zickzack-förmige Leiter besitzen.
5. Die Z-Strukturen zerlegen und auf zwei Substrate verteilen, so dass auf einem einzelnen Substrat keine Überdeckungen oder Kreuzungen entstehen.

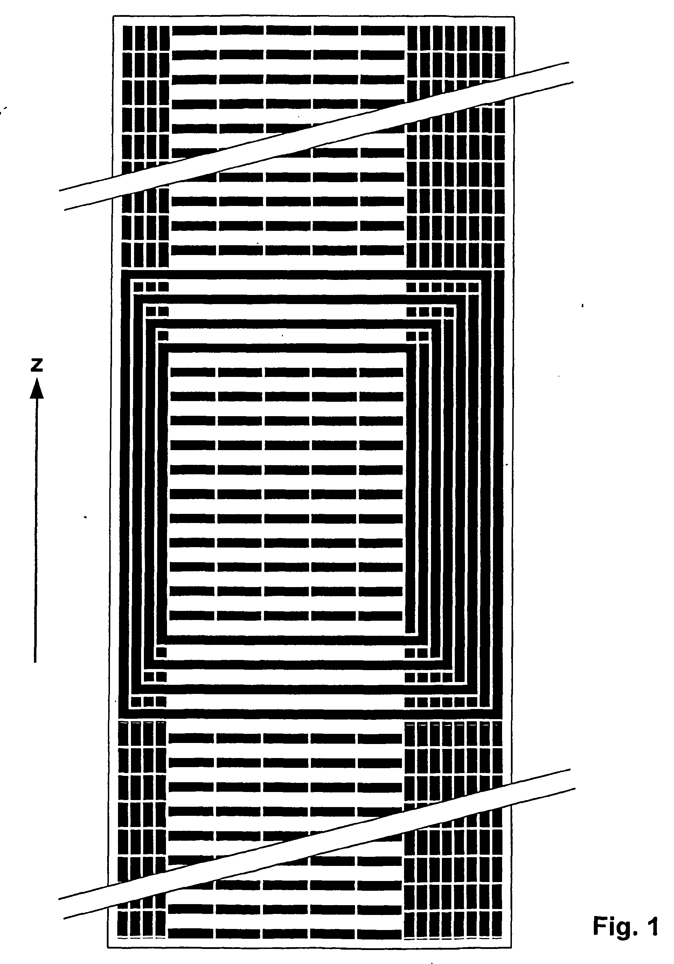

Die supraleitenden Leiter, die nicht zum HF-Resonator gehören, können zusätzlich noch mit schmalen Unterbrüchen versehen werden, um die HF-Kopplung mit dem HF-Resonator zu minimieren. Solche Unterbrüche sind in Fig. 1 für die zweite Ausführungsform dargestellt, sie können aber auch bei allen anderen Ausführungsformen realisiert werden, auch wenn diese dort nicht explizit dargestellt sind.

NMR-Resonatoren, deren Bauelemente eine von der Umgebung abweichende magnetische Suszeptibilität aufweisen, erzeugen im Allgemeinen Feldinhomogenitäten im aktiven Messbereich. Es ist bekannt, dass dieser Effekt dadurch kompensiert werden kann, dass die Bauelemente durch Zusatzmaterialien ergänzt werden, welche die gleiche Suszeptibilität wie die Bauelemente selbst besitzen und parallel zur z-Richtung genügend weit fortgesetzt sind. Die Zusatzmaterialien sind Isolatoren, die z.B. aus einer Flüssigkeit bestehen können, in der die Spule als ganzes eingetaucht betrieben wird. Wir wollen dieses Verfahren als "Suszeptibilitätsfortsetzendes Verfahren" bezeichnen und nachfolgend seine Unterschiede zur vorliegenden Erfindung angeben:

1. Das "Suszeptibilitätsfortsetzende Verfahren" wurde nur bei **normal leitenden** Metallen oder Isolatoren angewendet und kann im Allgemeinen auch nur für diese sinnvoll eingesetzt werden. Bei Supraleitern hingegen sind im Allgemeinen wesentlich stärkere Magnetisierungseffekte vorhanden, und deshalb sind auch andere Kompensationsmethoden erforderlich, z.B. solche gemäß der vorliegenden Erfindung.

2. Bei normal leitenden Materialen entsteht die Magnetisierung durch **magnetische Dipolmomente** innerhalb der Bauelemente, die zwangsläufig durch das $B_0$-Feld parallel zu diesem ausgerichtet werden. Beim Supraleiter hingegen entsteht die Magnetisierung durch Kompensationsströme in den supraleitenden Bauelementen. Der Einfluss dieser Ströme auf die Feldhomogenität im aktiven Messbereich kann Größenordnungen größer sein, als der Einfluss der magnetischen Dipolmomente.

3. Beim "Suszeptibilitätsfortsetzenden Verfahren" muss nur die **longitudinale Magnetisierung** der Bauelemente kompensiert werden, die transversale Magnetisierung ist vernachlässigbar klein. Beim Supraleiter hingegen ist die transversale Magnetisierung dominant und die longitudinale Magnetisierung ist nur von untergeordneter Bedeutung.

Aus der Literatur [7] ist ferner ein Verfahren bekannt, mit dem die Suszeptibilität eines NMR-Resonators wenigstens teilweise kompensiert wird, so dass ein minimierter Einfluss auf das NMR-Spektrum entsteht. Dieses Verfahren bezieht sich jedoch ebenfalls nur auf normalleitende Materialien und eliminiert die Feldstörungen nur auf der z-Achse, nicht aber im ganzen aktiven Messbereich. Die vorliegende Erfindung hingegen kompensiert die Feldstörungen im ganzen aktiven Messbereich.

Bezugszeichenliste zu den Figuren

**Buchstaben:**

B$_0$              Statisches Magnetfeld des NMR-Magneten.

$\Delta B$              Feld, das durch den magnetisierten Supraleiter erzeugt wird.

$(\Delta B_Z)_1$              z-Komponente von $\Delta B$ für einen einzelnen supraleitenden Streifen 2 oder 4.

$(\Delta B_Z)_{tot}$              z-Komponente von $\Delta B$ für die Anordnung 5, die aus mehreren supraleitenden Streifen zusammengesetzt ist.

S1, S3, S4, S5, S6    Einzelne geschlossene Strompfade in den supraleitenden Streifen

**Ziffern:**

1 Aktives Messvolumen.

2 Langer, flacher Leiter aus supraleitendem Material (= supraleitender Streifen), dessen Längsachse parallel zu B$_0$ gerichtet ist.

3 Ströme im supraleitenden Streifen 2.

4 Flacher Leiter aus supraleitendem Material (= supraleitender Streifen), dessen Längsachse senkrecht zu B$_0$ gerichtet ist.

4a, 4b, 4c, ..., 4k Supraleitende Streifen wie unter 4 beschrieben, die zur Anordnung 5 gehören.

5 Anordnung aus mehreren supraleitenden Streifen 4a, 4b, 4c, ... ,4k, die auf einer Ebene parallel zu B$_0$ liegen und gleichmäßig übereinander angeordnet sind.

6 Ströme im supraleitenden Streifen 4.

7a, 7b, 7c, 7d Bereiche der diversen Resonatoren, in denen sich die Leiterabschnitte befinden, die HF-Ströme tragen. Diese Leiterabschnitte definieren die HF-Resonatoren, d.h. die HF-Resonanzkreise.

8a, 8b Senkrechte Leiterstruktur parallel zur z-Achse, die teilweise dazu benützt wird, die senkrechten Leiteranteile des Resonators herzustellen, die am nächsten beim Probenvolumen liegen und dort den Hauptanteil des HF-Feldes erzeugen.

9a, 9b Waagrechte Leiterstruktur senkrecht zur z-Achse, die teilweise dazu benützt wird, um die waagrechten Querverbindungen oben und unten am HF-Resonator herzustellen.

10a, 10b Senkrechte Leiterstruktur parallel zur z-Achse, die teilweise dazu benützt wird, die kapazitiven Anteile des HF-Resonators herzustellen.

Referenzen

[1]    US 5,619,140
[2]    WO 99/24845
[3]    WO 99/24821
[4]    US 5,572,127
[5]    DE 197 33 574 A1
[6]    DE 101 18 835.8-33
[7]    DE 34 14 559 A1
[8]    WO 96/39636
[9]    US 5,565,778
[10]   US 6,025,719

**Patentansprüche**

1.  HF (= Hochfrequenz)-Empfangsspulenanordnung mit mindestens einem HF-Resonator zum Aussenden und/oder Empfangen von HF-Signalen auf einer oder mehreren Resonanzfrequenzen in eine und/oder aus einer Messprobe in einem um einen Koordinatenursprung (x,y,z = 0) angeordneten Untersuchungsvolumen einer NMR-(= Kernspinresonanz)-Apparatur mit einer Einrichtung zur Erzeugung eines homogenen Magnetfelds $B_0$ in Richtung einer z-Achse, wobei zwischen $z = -|z_1|$ und $z = +|z_2|$ supraleitfähige, induktiv und zum Teil auch kapazitiv wirkende Leiterstrukturen des HF-Resonators im wesentlichen auf einer Fläche, die in Flächenelemente eingeteilt werden kann, welche sich lediglich in ihrer z-Position unterscheiden, im radialen (x,y) Abstand von der Messprobe angeordnet sind,
    **dadurch gekennzeichnet,**
    **dass** auf der Fläche, deren Flächenelemente sich lediglich in ihrer z-Position unterscheiden, zusätzlich eine Kompensations-Anordnung vorgesehen ist, die sich mindestens bis zu Werten $z < -|z_1| -0.5\ |r|$ und $z > +|z_2| + 0.5\ |r|$ erstreckt, wobei $|r|$ der kleinste vorkommende Abstand zwischen der Messprobe und der Kompensations-Anordnung bedeutet,
    **dass** die Kompensations-Anordnung weitere supraleitfähige Leiterstrukturen umfasst, welche HF-mäßig vom HF-Resonator weitgehend entkoppelt sind,
    **dass** die Leiterstrukturen der Kompensations-Anordnung und des HF-Resonators ihrerseits aus einzelnen, supraleitende Strukturen enthaltenden Flächenabschnitten (="Z-Strukturen") zusammengesetzt sind, die in der Fläche liegen, jeweils über die ganze Länge in z-Richtung der Leiterstrukturen der Kompensations-Anordnung und des HF-Resonators verlaufen, und deren supraleitende Strukturen so angeordnet sind, dass im Falle einer Zerlegung der Fläche der Z-Strukturen in eine Vielzahl kleiner, gleich großer Flächenelemente durch Anlegen eines homogenen Testmagnetfeldes entlang der Flächennormalen jedes Flächenelementes für alle Flächenelemente, die sich nur in ihrer z-Position unterscheiden, ein magnetisches Dipolmoment von weitgehend derselben Stärke induziert wird.

2.  HF-Empfangsspulenanordnung nach Anspruch 1, **dadurch gekennzeichnet, dass** jeweils alle Flächenelemente, die sich nur in ihrer z-Position unterscheiden, im wesentlichen gleich viel Supraleitermaterial enthalten.

3.  HF-Empfangsspulenanordnung nach einem der vorhergehenden Ansprüche, **dadurch gekennzeichnet, dass** die supraleitfähigen Leiterstrukturen der Kompensations-Anordnung den HF-Resonator beidseits jeweils um mindestens die halbe, vorzugsweise etwa die zweifache Ausdehnung des HF-Resonators in z-Richtung überragen.

4. HF-Empfangsspulenanordnung, die aus mehreren, vorzugsweise 2 oder 4 HF-Empfangsspulenanordnungen nach einem der vorhergehenden Ansprüche aufgebaut ist, wobei diese HF-Empfangsspulenanordnungen miteinander HF-mäßig koppeln und auf unterschiedlichen Teilflächen der Fläche, die in Flächenelemente eingeteilt werden kann, welche sich lediglich in ihrer z-Position unterscheiden, liegen.

5. HF-Empfangsspulenanordnung nach einem der vorhergehenden Ansprüche, **dadurch gekennzeichnet, dass** die supraleitfähigen, induktiv und zum Teil auch kapazitiv wirkenden Leiterstrukturen des oder der HF-Resonatoren und die supraleitfähigen Leiterstrukturen der Kompensations-Anordnung(en) auf ebenen Substratelementen aufgebracht sind, die untereinander und zur z-Achse parallel angeordnet sind.

6. HF-Empfangsspulenanordnung nach einem der vorhergehenden Ansprüche, **dadurch gekennzeichnet, dass** die supraleitfähigen, induktiv und zum Teil auch kapazitiv wirkenden Leiterstrukturen des HF-Resonators und die supraleitfähigen Leiterstrukturen der zugehörigen Kompensations-Anordnung in derselben Ebene angeordnet sind.

7. HF-Empfangsspulenanordnung nach einem der Ansprüche 1 bis 5, **dadurch gekennzeichnet, dass** die supraleitfähigen Strukturen des HF-Resonators und der zugehörigen Kompensationsanordnung in zwei oder mehreren ebenen Teilflächen liegen, die parallel zueinander angeordnet sind, wobei in der ersten Teilfläche die supraleitfähigen, induktiv und zum Teil auch kapazitiv wirkenden Leiterstrukturen des HF-Resonators sowie Teile der zugehörigen supraleitfähigen Leiterstrukturen der Kompensations-Anordnung, in den weiteren Teilflächen die verbleibenden Teile der supraleitfähigen Leiterstrukturen der Kompensations-Anordnung angeordnet sind.

8. HF-Empfangsspulenanordnung nach einem der Ansprüche 1 bis 4, ggf. in Verbindung mit Anspruch 7, **dadurch gekennzeichnet, dass** die supraleitfähigen, induktiv und zum Teil auch kapazitiv wirkenden Leiterstrukturen des oder der HF-Resonatoren und die supraleitfähigen Leiterstrukturen der Kompensations-Anordnung(en) auf flächigen Substratelementen aufgebracht sind, die zylindrisch um die z-Richtung gekrümmt sind.

9. HF-Empfangsspulenanordnung nach einem der vorhergehenden Ansprüche, **dadurch gekennzeichnet, dass** die Leiterstrukturen der Kompensations-Anordnung und des HF-Resonators auf derselben Teilfläche der Fläche, die in Flächenelemente eingeteilt werden kann, welche sich lediglich in ihrer z-Position unterscheiden, angeordnet sind.

10. HF-Empfangsspulenanordnung nach einem der vorhergehenden Ansprüche, **dadurch gekennzeichnet, dass** zumindest ein Teil der supraleitfähigen Abschnitte der Leiterstrukturen streifenförmig achsparallel oder achssenkrecht zur z-Richtung angeordnet ist.

11. HF-Empfangsspulenanordnung nach einem der vorhergehenden Ansprüche, **dadurch gekennzeichnet, dass** eine oder mehrere ihrer Z-Strukturen aus identischen, schmalen supraleitenden Strukturelementen aufgebaut sind, und diese Strukturelemente aus einem einzelnen Leiter oder in Gruppen angeordneten Leitern bestehen, die eng aufeinander folgend und periodisch kontinuierlich in z-Richtung angeordnet sind, wobei der Abstand benachbarter Strukturelemente klein gegenüber dem Abstand zum Zentrum des Untersuchungsvolumens ist.

12. HF-Empfangsspulenanordnung nach einem der vorhergehenden Ansprüche, **dadurch gekennzeichnet, dass** eine oder mehrere ihrer Z-Strukturen aus Strukturelementen zusammengestellt sind, die aus einem einzelnen Leiter oder in Gruppen angeordneten Leitern bestehen, wobei die Leiterabschnitte parallel zur z-Achse ausgerichtet sind und gleiche oder unterschiedliche Abstände zueinander haben.

13. HF-Empfangsspulenanordnung nach einem der Ansprüche 1 bis 10, **dadurch gekennzeichnet, dass** eine oder mehrere ihrer Z-Strukturen in mehrere, vorzugsweise rechteckige Teilbereiche eingeteilt werden, deren Breite gleich der Breite der jeweiligen Z-Struktur ist, und dass diese Teilbereiche durch gerade supraleitende Streifen gefüllt werden, die um einen gewünschten Winkel zur z-Achse geneigt sind, wobei dieser Winkel innerhalb eines Teilbereiches entweder positiv oder negativ ist, und dass die geneigten Streifen innerhalb eines Teilbereiches eng aufeinander folgend und periodisch kontinuierlich in z-Richtung angeordnet sind, wobei der Abstand benachbarter Streifen klein gegenüber dem Abstand zum Zentrum des Untersuchungsvolumens ist, und dass die geneigten Streifen an den Grenzlinien zwischen den Teilbereichen kontinuierlich ineinander übergehen.

14. HF-Empfangsspulenanordnung nach einem der vorhergehenden Ansprüche, **dadurch gekennzeichnet, dass** die supraleitfähigen Leiterstrukturen, die nicht zum HF-Resonator gehören, eine Anzahl von schmalen Unterbrüchen enthalten, die über Teile oder die ganze Länge der einzelnen supraleitenden Leiterabschnitte verteilt sind.

**15.** HF-Empfangsspulenanordnung nach einem der Ansprüche 1 bis 10, **dadurch gekennzeichnet, dass** die Erzeugung des HF-Resonators aus den gewünschten Bereichen der Z-Strukturen dadurch erreicht wird, dass innerhalb von kleinen Flächenelementen der Z-Strukturen der Supraleiter oder Teile davon gedreht oder verschoben werden, und/oder dass schmale Abstände zwischen den Leitern supraleitend verbunden werden, und/oder dass schmale Unterbrüche in den Leitern angebracht werden, und/oder dass zickzackförmige und schräge Z-Strukturen verwendet werden, und/oder dass die Z-Strukturen auf zwei oder mehreren Teilflächen verteilt werden.

**16.** HF-Empfangsspulenanordnung nach einem der Ansprüche 1 bis 12 oder 14 bis 15, **dadurch gekennzeichnet, dass** diese aus drei Z-Strukturen aufgebaut ist, nämlich links und rechts je eine mit vertikalen und dazwischen eine mit horizontalen geraden Streifen.

**17.** HF-Empfangsspulenanordnung nach einem der Ansprüche 1 bis 15, **dadurch gekennzeichnet, dass** diese aus drei Z-Strukturen aufgebaut ist, nämlich links und rechts je eine mit schrägen, teilweise zickzackförmigen, und dazwischen eine mit in z-Richtung periodisch angeordneten Querstreifen.

**18.** HF-Empfangsspulenanordnung nach einem der Ansprüche 1 bis 12 oder 14 bis 15, **dadurch gekennzeichnet, dass** diese aus drei Z-Strukturen zusammengesetzt ist, nämlich aus einer ersten und zweiten mit parallel zur z-Achse sowie einer dritten mit in z periodisch und quer zur z-Achse angeordneten Streifen, wobei die dritte Z-Struktur über den beiden ersten, die einen bestimmten Abstand zueinander haben, positioniert ist und diese genau überdeckt, und wobei die Zusammensetzung des HF-Resonators und der Kompensationsstruktur dadurch erfolgt, dass die drei Z-Strukturen teilweise zerlegt und auf zwei separaten Teilflächen, die zu einem oder zwei Substraten gehören, verteilt werden, wobei die erste Teilfläche den ganzen HF-Resonator mit dem Hauptanteil der Kompensations-Struktur, und die zweite Teilfläche den Restanteil der Kompensations-Struktur enthält, und dass die so entstandenen Strukturen auf den beiden Teilflächen derart aufeinander positioniert werden, dass die Summe ihrer Strukturen wieder gleich der Summe der ursprünglichen drei Z-Strukturen ist, und dass dadurch ein funktionsfähiger NMR-Resonator entsteht.

**Claims**

**1.** RF (radio frequency) receiver coil arrangement comprising at least one RF resonator for emitting and/or receiving RF signals at one or more resonance frequencies to and/or from a measuring sample in an investigational volume, disposed about a coordinate origin (x,y,z = 0), of an NMR (nuclear magnetic resonance) apparatus with a means for producing a homogeneous magnetic field $B_0$ in the direction of a z axis, wherein superconducting conductor structures of the RF resonator, which act inductively and partially also capacitively, are disposed between $z= -|z_1|$ and $z = +|z_2|$ substantially on a surface, which can be divided into surface elements which differ from each other only with regard to their z position, at a radial (x,y) separation from the measuring sample, **characterized in that** an additional compensation arrangement is provided on the surface whose surface elements differ from each other only with regard to their z position, and extends to values of at least $z < -|z_1| -0.5 |r|$ and $z > +|z_2| +0.5 |r|$, wherein $|r|$ is the minimum separation between the measuring sample and the compensation arrangement, with the compensation arrangement comprising further superconducting conductor structures which are largely RF-decoupled from the RF resonator, wherein the conductor structures of the compensation arrangement and of the RF resonator are composed of individual surface sections ("Z-structures") which comprise superconducting structures, lie in the surface, and each extend across the entire length in the z direction of the conductor structures of the compensation arrangement and of the RF resonator, and whose superconducting structures are disposed such that, with conceptual decomposition of the surface of the Z structures into a plurality of small, equally sized surface elements, and with conceptual application of a homogeneous test magnetic field along the surface normal of each surface element, a magnetic dipole moment of essentially the same strength would be induced in all surface elements which differ from each other only with respect to their z position.

**2.** RF receiver coil arrangement according to claim 1, **characterized in that** all surface elements which differ with respect to their z position only, contain substantially equal amounts of superconducting material.

**3.** RF receiver coil arrangement according to any one of the preceding claims, **characterized in that** the superconducting conductor structures of the compensation arrangement project past both sides of the RF resonator by at least half, preferably approximately twice the extension of the RF resonator in the z direction.

**4.** RF receiver coil arrangement which is built from several, preferably 2 or 4 RF receiver coil arrangements according to any one of the preceding claims, wherein these RF receiver coil arrangements are RF-coupled to each other and lie on different partial surfaces of the surface, which can be divided into surface elements which differ from each other only with respect to their z position.

5. RF receiver coil arrangement according to any one of the preceding claims, **characterized in that** the superconducting conductor structures of the RF resonator(s), which act inductively and partially also capacitively, and the superconducting conductor structures of the compensation arrangement(s), are disposed on flat substrate elements which are disposed parallel to each other and to the z axis.

6. RF receiver coil arrangement according to any one of the preceding claims, **characterized in that** the superconducting conductor structures of the RF resonator, which act inductively and partially also capacitively, and the superconducting conductor structures of the associated compensation arrangement are disposed in the same plane.

7. RF receiver coil arrangement according to any one of the claims 1 through 5, **characterized in that** the superconducting structures of the RF resonator and of the associated compensation arrangement are disposed in two or more flat partial surfaces which are arranged parallel to each other, wherein the superconducting conductor structures of the RF resonator, which act inductively and partially also capacitively, and parts of the associated superconducting conductor structures of the compensation arrangement are disposed in the first partial surface, and the remaining parts of the superconducting conductor structures of the compensation arrangement are disposed in the other partial surfaces.

8. RF receiver coil arrangement according to any one of the claims 1 through 4, optionally in connection with claim 7, **characterized in that** the superconducting conductor structures of the RF resonator(s), which act inductively and partially also capacitively, and the superconducting conductor structures of the compensation arrangement(s) are disposed on flat substrate elements which are cylindrically curved about the z direction.

9. RF receiver coil arrangement according to any one of the preceding claims, **characterized in that** the conductor structures of the compensation arrangement and of the RF resonator are disposed on the same partial surface of the surface which can be divided into surface elements which differ from each other only with regard to their z position.

10. RF receiver coil arrangement according to any one of the preceding claims, **characterized in that** at least part of the superconducting sections of the conductor structures is disposed in strips parallel or perpendicular to the z direction.

11. RF receiver coil arrangement according to any one of the preceding claims, **characterized in that** one or more of its Z structures is/are built from identical, narrow superconducting structural elements and these structural elements consist of one single conductor or of conductors disposed in groups, which are disposed in close proximity and with periodic continuity in the z direction, wherein the separation between neighboring structural elements is small compared to the separation from the center of the volume under investigation.

12. RF receiver coil arrangement according to any one of the preceding claims, **characterized in that** one or more of its Z structures is/are composed of structural elements which consist of one individual conductor or of conductors disposed in groups, wherein the conductor sections are oriented parallel to the z axis and have identical or different mutual separations.

13. RF receiver coil arrangement according to any one of the claims 1 through 10, **characterized in that** one or more of its Z structures is/are divided into several, preferably rectangular partial regions whose width is equal to the width of the respective Z structure and that these partial regions are filled by straight superconducting strips which are inclined by a desired angle relative to the z axis, wherein this angle is either positive or negative within a partial region and that the inclined strips are disposed with close proximity and periodic continuity in the z direction within one partial region, wherein the separation between neighboring strips is small compared to the separation from the center of the volume under investigation and the inclined strips merge continuously at the border lines between the partial regions.

14. RF receiver coil arrangement according to any one of the preceding claims, **characterized in that** the superconducting conductor structures which do not belong to the RF resonator contain a number of narrow interruptions which are distributed over parts or over the entire length of the individual superconducting conductor sections.

**15.** RF receiver coil arrangement according to any one of the claims 1 through 10, **characterized in that** the RF resonator is produced from the desired regions of the Z structures by rotating or displacing the superconductor or parts thereof within small surface elements of the Z structures, and/or by superconductingly connecting small separations between the conductors, and/or by disposing narrow interruptions in the conductors, and/or by using zig-zag shaped and inclined Z structures, and/or by distributing the Z structures on two or more partial surfaces.

**16.** RF receiver coil arrangement according to any one of the claims 1 through 12 or 14 to 15, **characterized in that** it is built from three Z structures, two with vertical strips on the left and right and one with horizontal straight strips in the center.

**17.** RF receiver coil arrangement according to any one of the claims 1 through 15, **characterized in that** it is built from three Z structures, two with inclined, partially zig-zag shaped strips on the left and on the right, and one central structure having transverse strips periodically disposed in the z direction.

**18.** RF receiver coil arrangement according to any one of the claims 1 through 12 or 14 through 15, **characterized in that** it is composed of three Z structures, a first and second structure having a defined mutual separation and each comprising strips disposed parallel to the z axis and a third structure with strips disposed periodically in z and transverse to the z axis, wherein the third Z structure is positioned above the first two and covers them exactly, and wherein the RF resonator and the compensation structure are generated **in that** the three z structures are partially decomposed and distributed over two separate partial surfaces which belong to one or two substrates, wherein the first partial surface contains the entire RF resonator with the main part of the compensation structure and the second partial surface contains the remaining part of the compensation structure, and the structures produced in this fashion are positioned on the two partial surfaces such that the sum of their structures is again equal to the sum of the original three Z structures, thereby producing an operative NMR resonator.

**Revendications**

**1.** Agencement de bobines de réception HF (= haute fréquence) avec au moins un résonateur HF pour l'émission et/ou la réception de signaux HF sur une ou plusieurs fréquences de résonance vers et/ou depuis un échantillon à mesurer dans un volume d'analyse disposé autour d'une origine de coordonnées (x, y, z = 0) d'un appareillage RMN (= résonance magnétique nucléaire) avec un dispositif pour générer un champ magnétique homogène $B_0$ en direction d'un axe z, sachant qu'entre z = - $|z_1|$ et z = + $|z_2|$ des structures de conducteurs supraconductrices, ayant un effet inductif et en partie aussi capacitif du résonateur HF sont disposées essentiellement sur une surface qui peut être divisée en éléments de surface qui diffèrent seulement par leur position z à distance radiale (x, y) de l'échantillon à mesurer,
**caractérisé en ce**
**que** sur la surface dont les éléments de surface diffèrent seulement par leur position z, il est prévu en plus un dispositif de compensation qui s'étend au moins jusqu'à des valeurs z < -$|z_1|$- 0.5 $|r|$ et z > +$|z_2|$+ 0.5 $|r|$, $|r|$ représentant la plus petite distance existant entre l'échantillon à mesurer et le dispositif de compensation,
**que** le dispositif de compensation comprend d'autres structures de conducteurs supraconductrices qui sont en grande partie découplées du point de vue HF du résonateur HF,
**que** les structures de conducteurs du dispositif de compensation et du résonateur HF sont elles-mêmes composées de sections de surface (= « structures Z ») individuelles, contenant des structures supraconductrices, qui se situent dans la surface, s'étendent chacune sur toute la longueur en direction z des structures de conducteurs du dispositif de compensation et du résonateur HF, et dont les structures supraconductrices sont disposées de façon qu'en cas de décomposition de la surface des structures Z en une pluralité de petits éléments de surface de même dimension, par application d'un champ magnétique homogène d'essai le long de la normale à la surface de chaque élément de surface, un moment dipolaire magnétique d'une intensité essentiellement égale est induit pour tous les éléments de surface qui diffèrent seulement par leur position z.

**2.** Agencement de bobines de réception HF selon la revendication 1, **caractérisé en ce que** tous les éléments de surface qui diffèrent seulement par leur position z contiennent essentiellement la même quantité de matériau supraconducteur.

**3.** Agencement de bobines de réception HF selon l'une des revendications précédentes, **caractérisé en ce que** les structures de conducteurs supraconductrices du dispositif de compensation dépassent de chaque côté du résonateur HF d'au moins la moitié, de préférence environ le double de l'extension du résonateur HF en direction z.

**4.** Agencement de bobines de réception HF qui est constitué de plusieurs, de préférence 2 ou 4 agencements de bobines de réception HF selon l'une des revendications précédentes, ces agencements de bobines de réception HF étant couplés les uns aux autres du point de vue HF et étant situés sur différentes sous-surfaces de la surface qui peut être divisée en éléments de surface qui diffèrent seulement par leur position z.

**5.** Agencement de bobines de réception HF selon l'une des revendications précédentes, **caractérisé en ce que** les structures de conducteurs supraconductrices, ayant un effet inductif et en partie aussi capacitif du ou des résonateur (s) HF et les structures de conducteurs supraconductrices du ou des dispositif(s) de compensation sont montées sur des éléments de substrat plans qui sont disposés parallèlement les uns aux autres et à l'axe z.

**6.** Agencement de bobines de réception HF selon l'une des revendications précédentes, **caractérisé en ce que** les structures de conducteurs supraconductrices, ayant un effet inductif et en partie aussi capacitif du résonateur HF et les structures de conducteurs supraconductrices du dispositif de compensation associé sont disposées dans le même plan.

**7.** Agencement de bobines de réception HF selon l'une des revendications 1 à 5, **caractérisé en ce que** les structures supraconductrices du résonateur HF et du dispositif de compensation associé sont situées dans deux ou plus sous-surfaces planes qui sont disposés parallèlement l'une à l'autre, les structures de conducteurs supraconductrices, ayant un effet inductif et en partie aussi capacitif du résonateur HF ainsi que des parties des structures de conducteurs supraconductrices du dispositif de compensation associé étant disposées dans la première sous-surface, les parties restantes des structures de conducteurs supraconductrices du dispositif de compensation dans l'autre sous-surface.

**8.** Agencement de bobines de réception HF selon l'une des revendications 1 à 4, le cas échéant en relation avec la revendication 7, **caractérisé en ce que** les structures de conducteurs supraconductrices, ayant un effet inductif et en partie aussi capacitif du ou des résonateur(s) HF et les structures de conducteurs supraconductrices du ou des dispositif(s) de compensation sont montées sur des éléments de substrat plans qui sont courbés cylindriquement autour de la direction z.

**9.** Agencement de bobines de réception HF selon l'une des revendications précédentes, **caractérisé en ce que** les structures de conducteurs du dispositif de compensation et du résonateur HF sont disposées sur la même sous-surface de la surface qui peut être divisée en éléments de surface qui diffèrent seulement par leur position z.

**10.** Agencement de bobines de réception HF selon l'une des revendications précédentes, **caractérisé en ce qu'**au moins une partie des sections supraconductrices des structures de conducteurs est disposée en bande parallèlement à l'axe ou perpendiculairement à l'axe par rapport à la direction z.

**11.** Agencement de bobines de réception HF selon l'une des revendications précédentes, **caractérisé en ce que** une ou plusieurs de ses structures Z sont constituées d'éléments de structure supraconducteurs étroits identiques et que ces éléments de structure sont composés d'un seul conducteur ou de conducteurs disposés en groupes qui sont disposés de manière étroitement successive et périodiquement continue en direction z, la distance entre éléments de structure voisins étant petite par rapport à la distance au centre du volume d'analyse.

**12.** Agencement de bobines de réception HF selon l'une des revendications précédentes, **caractérisé en ce que** une ou plusieurs de ses structures Z sont constituées d'éléments de structure qui sont composés d'un seul conducteur ou de conducteurs disposés en groupes, les sections de conducteurs étant orientées parallèlement à l'axe z et ayant entre elles des distances égales ou différentes.

**13.** Agencement de bobines de réception HF selon l'une des revendications 1 à 10, **caractérisé en ce qu'**une ou plusieurs de ses structures Z sont divisées en plusieurs sous-secteurs, de préférence rectangulaires, dont la largeur est égale à la largeur de la structure Z respective, et que ces sous-secteurs sont remplis par des bandes supraconductrices rectilignes qui sont inclinées d'un angle souhaité par rapport à l'axe z, cet angle étant soit positif, soit négatif à l'intérieur d'un sous-secteur, et que les bandes inclinées sont disposées de manière étroitement successive et périodiquement continue en direction z à l'intérieur d'un sous-secteur, la distance entre bandes voisines étant petite par rapport à la distance au centre du volume d'analyse, et que les bandes inclinées passent les unes aux autres de manière continue aux frontières entre les sous-secteurs.

**14.** Agencement de bobines de réception HF selon l'une des revendications précédentes, **caractérisé en ce que** les structures de conducteurs supraconductrices qui n'appartiennent pas au résonateur HF contiennent un certain nombre d'étroites interruptions qui sont réparties sur des parties ou sur toute la longueur des différentes sections de conducteurs supraconductrices.

15. Agencement de bobines de réception HF selon l'une des revendications 1 à 10, **caractérisé en ce que** la production du résonateur HF à partir des secteurs souhaités des structures Z est obtenue en tournant ou déplaçant le supraconducteur ou des parties de celui-ci à l'intérieur de petits éléments de surface des structures Z et/ou en reliant de manière supraconductrice d'étroits espaces entre les conducteurs et/ou en appliquant d'étroites interruptions dans les conducteurs et/ou en utilisant des structures Z en zigzag et obliques et/ou en répartissant les structures Z sur deux ou plusieurs sous-surfaces.

16. Agencement de bobines de réception HF selon l'une des revendications 1 à 12 ou 14 à 15, **caractérisé en ce qu'**il est constitué de trois structures Z, à savoir une à gauche et une à droite chaque fois avec des bandes verticales et une entre les deux avec des bandes rectilignes horizontales.

17. Agencement de bobines de réception HF selon l'une des revendications 1 bis 15, **caractérisé en ce que** qu'il est constitué de trois structures Z, à savoir une à gauche et une à droite chaque fois avec des bandes obliques, partiellement en zigzag, et une entre les deux avec des bandes transversales disposées périodiquement en direction z.

18. Agencement de bobines de réception HF selon l'une des revendications 1 à 12 ou 14 à 15, **caractérisé en ce qu'**il est constitué de trois structures Z, à savoir d'une première et d'une deuxième avec des bandes disposées parallèlement à l'axe z ainsi que d'une troisième avec des bandes disposées périodiquement en z et transversalement à l'axe z, la troisième structure Z étant positionnée au-dessus des deux premières qui ont une certaine distance entre elles et les recouvrant exactement, et la composition du résonateur HF et de la structure de compensation étant réalisée par le fait que les trois structures Z sont partiellement décomposées et réparties sur deux sous-surfaces séparées qui appartiennent à un ou deux substrats, la première sous-surface contenant tout le résonateur HF avec la part principale de la structure de compensation et la deuxième sous-surface la part restante de la structure de compensation, et que les structures ainsi formées sont positionnées l'une sur l'autre sur les deux sous-surfaces de façon que la sommes de leurs structures soit de nouveau égale à la somme des trois structures Z d'origine et qu'il en résulte un résonateur RMN opérationnel.

Fig. 1

**Fig. 2**

Fig. 3

Fig. 4

**Fig. 5**

$B_0$

$\Delta B$     $\Delta B$

4

$\Delta B$

$(\Delta B_Z)_1$

z

$\Delta B$

d

x

1

$\Delta B$

$\Delta B$

$\Delta B$

$(\Delta B_Z)_1$

Fig. 6

$\Delta B$     $\Delta B$

w

b

a

$B_0$

z

y

x

1

$\Delta B$     $\Delta B$

Fig. 7

Fig. 8

Fig. 9a

Fig. 9b

Fig. 9c

Fig. 9d

Fig. 9e

Fig. 9f

Fig. 10a

Fig. 10b

Fig. 11a

**Fig. 11b**

**Fig. 11c**

Z

7a

Fig. 12a

Fig. 12b

Fig. 13

$L_A = L_B$

Fig. 16a

Fig. 16b

Z

**Fig. 14a**

**Fig. 14b**

Fig. 16c

7d

Z

Fig. 16d

**Fig. 15a**                    **Fig. 15b**

**Fig. 16a**

**Fig. 16b**

**Fig. 16c**

**Fig. 16d**

Fig. 17a

Fig. 17b

**EP 1 302 780 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5585723 A
- US 5619140 A
- WO 9924845 A
- WO 9924821 A
- US 5572127 A
- DE 19733574 A1
- DE 10118835833
- DE 3414559 A1
- WO 9639636 A
- US 5565778 A
- US 6025719 A